# EUROPEAN PATENT APPLICATION

(11) **EP 4 586 314 A1**
(43) Date of publication of application: **16.07.2025**
(21) Application number: 23862958.8
(22) Date of filing: 24.08.2023
(51) Int. Cl.: H01L 23/50, H01L 23/12

(54) **PIN CONTROL DEVICE, PIN INSERTION DEVICE, REMAINING PIN REMOVAL DEVICE, PIN INSERTION METHOD AND REMAINING PIN REMOVAL METHOD**

(30) Priority: 09.09.2022 JP 2022144193
(71) Applicant: Toyama Prefectural University, Toyama, 939-0398 (JP); Finecs Co., Ltd., Toyama 930-0281 (JP)
(72) Inventor: SHIMOYAMA, Isao, Imizu-shi, Toyama 939-0398 (JP); NODA, Kentaro, Imizu-shi, Toyama 939-0398 (JP); TSUKAGOSHI, Takuya, Imizu-shi, Toyama 939-0398 (JP); MATSUI, Tsuyoshi, Nakaniikawa-gun, Toyama 930-0281 (JP); NOJIMA, Satoshi, Nakaniikawa-gun, Toyama 930-0281 (JP); TAKANAMI, Sho, Nakaniikawa-gun, Toyama 930-0281 (JP)
(74) Representative: Strehl & Partner mbB
(86) International application number: PCT/JP2023/030576
(87) International publication number: WO 2024/053419

(57) **Abstract**

There is provided a pin control device, a pin insertion device, a remaining pin removal device, a pin insertion method, and a remaining pin removal method capable of efficiently inserting a pin into an insertion portion of a pin receiving member having the insertion portion into which the pin is to be inserted and/or removing a remaining pin without being inserted into the insertion portion. A pin control device 1 includes a support portion 2 that supports one or more flat plate-shaped pin receiving members M each having a plurality of insertion portions H, and a magnet portion 3 that generates a magnetic field, and the pin control device 1 changes a posture and a position of at least a part of a plurality of pins P placed on the pin receiving member M by causing at least one of the support portion 2 or the magnet portion 3 to slide relative to the other.

## Description

### Technical Field

The present invention relates to a pin control device that can control a plurality of pins placed on a pin receiving member having insertion portions into which the pins are to be inserted, thereby inserting the pins into the insertion portions and/or removing remaining pins that remain without being inserted into the insertion portions, a pin insertion device and a pin insertion method for inserting the pins into the insertion portions of the pin receiving member, and a remaining pin removal device and a remaining pin removal method for removing the remaining pins that remain without being inserted into the insertion portions.

### Background Art

The related art of Patent Literature 1 below discloses a method of swinging a base substrate wafer in a circumferential direction while swinging the base substrate wafer in order to insert a core member of a rivet member serving as a pin from a first surface side of the base substrate wafer and dispose the core member of the rivet member inside a through hole.

However, this method does not allow the rivet member to be inserted into the through hole quickly and reliably, and thus the following method is disclosed in Patent Literature 1. By relatively scanning a first substrate and a magnet disposed on a lower surface side of the first substrate, the rivet member corresponding to the pin moves together with the magnet while being attracted by the magnet, and when the rivet member passes through an opening portion of a concave portion as the insertion portion, the core member of the rivet member is attracted by the magnet via the concave portion, and the core member is inserted into the concave portion.

### Citation List

### Patent Literature

Patent Literature 1: JP2011-193289A

### Summary of Invention

### Technical Problem

However, in the technique disclosed in Patent Literature 1, the pins cannot be efficiently inserted into the insertion portions of the flat plate-shaped pin receiving member provided with the insertion portions such that the pins are inserted. In addition, after the pins are inserted into the insertion portions of the pin receiving member, the remaining pins that remain on the pin receiving member without being inserted into the insertion portions cannot be efficiently removed.

Therefore, one object of the present invention is to provide a pin control device that can efficiently insert pins into insertion portions of a pin receiving member having the insertion portions into which the pins are to be inserted, and/or that can remove a remaining pin that is present without being inserted into the insertion portion. An object of the present invention is to provide a pin insertion device and a pin insertion method that can efficiently insert pins into insertion portions provided in a flat plate-shaped pin receiving member. An object of the present invention is to provide a remaining pin removal device and a remaining pin removal method that efficiently remove a pin remaining on a pin receiving member. Other objects will be described in detail in the embodiments of the present invention.

### Solution to Problem

According to an aspect of the present invention, there is provided a pin control device including: a support portion that supports one or more flat plate-shaped pin receiving members each having a plurality of insertion portions; and a magnet portion that generates a magnetic field, in which a posture and a position of at least a part of a plurality of pins placed on the pin receiving member are changed by causing at least one of the support portion or the magnet portion to slide relative to the other.

According to an aspect of the present invention, there is provided a pin insertion device including: a support portion that supports one or more flat plate-shaped pin receiving members each having a plurality of insertion portions; and a magnet portion configured to at least simultaneously generate a magnetic field having a first orientation in a direction intersecting the pin receiving member and a magnetic field having a second orientation opposite to the first orientation in the direction intersecting the pin receiving member, in which by relatively moving, along the pin receiving member, a boundary between a region in which the magnetic field having the first orientation is generated and a region in which the magnetic field having the second orientation is generated, a posture and a position of at least a part of a plurality of pins placed on the pin receiving member are changed, and a part of the plurality of pins are inserted into the corresponding insertion portions.

According to an aspect of the present invention, there is provided a remaining pin removal device disposed close to a pin insertion device, the pin insertion device including a support portion that supports one or more flat plate-shaped pin receiving members each having a plurality of insertion portions, the remaining pin removal device including: a plate portion close to the pin receiving member so as to form a substantially flush surface with the pin receiving member, in which a magnet portion that generates a magnetic field slides from below the pin receiving member to below the plate portion or from above the pin receiving member to above the plate portion, whereby a remaining pin on the pin receiving member without being inserted into the insertion portion is moved from the pin receiving member onto the plate portion, and the remaining pin is removed from the pin receiving member.

According to an aspect of the present invention, there is provided a pin insertion method including: disposing a magnet portion with respect to one or more flat plate-shaped pin receiving members each having a plurality of insertion portions, the magnet portion generating a magnetic field having a first orientation in a direction intersecting the pin receiving member and a magnetic field having a second orientation opposite to the first orientation in the direction intersecting the pin receiving member; and relatively moving, along the pin receiving member, a boundary between a region in which the magnetic field having the first orientation is generated and a region in which the magnetic field having the second orientation is generated, whereby a posture of at least a part of a plurality of pins placed on the pin receiving member is changed, and a part of the plurality of pins are inserted into the corresponding insertion portions.

According to an aspect of the present invention, there is provided a remaining pin removal method including: moving a magnet portion disposed above or below one or more flat plate-shaped pin receiving members, thereby moving, from the pin receiving member, a remaining pin on the pin receiving member without being inserted into a plurality of insertion portions of the pin receiving member and removing the remaining pin. Advantageous Effects of Invention

According to the present invention, the pins can be efficiently inserted into the insertion portions provided on the pin receiving member, and the pins remaining on the pin receiving member can be efficiently removed.

### Brief Description of Drawings

[Fig. 1] Fig. 1 is a schematic diagram of a pin control device according to a first embodiment of the present invention, in which an upper part is a side view and a lower part is a plan view.
[Fig. 2] Fig. 2 is a schematic diagram of a pin insertion device according to a second embodiment of the present invention.
[Fig. 3] Fig. 3 is a diagram illustrating a pin insertion method applied to the pin insertion device illustrated in Fig. 2.
[Fig. 4A] Fig. 4A is a diagram illustrating magnetic field lines when a magnet portion is implemented by a magnet having a first region and a second region, and magnetization orientations in the first region and the second region are opposite to each other.
[Fig. 4B] Fig. 4B is a diagram illustrating magnetic field lines when a magnet portion is implemented by a magnet having a first region and a second region, and magnetization orientations in the first region and the second region are the same.
[Fig. 4C] Fig. 4C is a diagram illustrating magnetic field lines when a magnet portion is implemented by one magnet magnetized in one direction and in one orientation.
[Fig. 5] Fig. 5 is a diagram for examining a pin insertion probability.
[Fig. 6A] Fig. 6A is a plan view illustrating a first example of a relation between an arrangement state of insertion portions of a pin receiving member and dimensions of the magnet portion in a plan view.
[Fig. 6B] Fig. 6B is a plan view illustrating a second example of a relation between an arrangement state of insertion portions of the pin receiving member and dimensions of the magnet portion in a plan view.
[Fig. 7A] Fig. 7A is a diagram schematically illustrating a configuration of a magnet portion in a pin insertion device according to a third embodiment of the present invention.
[Fig. 7B] Fig. 7B is a diagram illustrating a use mode of one of electromagnets illustrated in Fig. 7A.
[Fig. 7C] Fig. 7C is a diagram illustrating one column or one row of electromagnets in the magnet portion illustrated in Fig. 7A.
[Fig. 7D] Fig. 7D is a diagram schematically illustrating a change in a magnetic field generated in the magnet portion illustrated in Fig. 7A.
[Fig. 8A] Fig. 8A is a plan view illustrating an outline of a pin insertion device according to a fourth embodiment of the present invention.
[Fig. 8B] Fig. 8B is a partial sectional view illustrating an outline of the pin insertion device according to the fourth embodiment of the present invention.
[Fig. 8C] Fig. 8C is a partially enlarged view of Fig. 8B.
[Fig. 8D] Fig. 8D is a schematic diagram of a magnet portion illustrated in Fig. 8B.
[Fig. 9A] Fig. 9A is a perspective view schematically illustrating a pin insertion device according to a fifth embodiment of the present invention.
[Fig. 9B] Fig. 9B is a diagram illustrating a main part of the pin insertion device illustrated in Fig. 9A.
[Fig. 10] Fig. 10 is a diagram illustrating a remaining pin removal step performed by a remaining pin removal device according to a sixth embodiment of the present invention.
[Fig. 11] Fig. 11 is a diagram illustrating results obtained by measuring a magnetic flux density of one magnet constituting the used magnet portion.
[Fig. 12] Fig. 12 is a diagram illustrating a method of determining a polarity of the used magnet portions.
[Fig. 13] Fig. 13 is a diagram schematically illustrating a strength of a magnetic force in divided portions of the used magnet portion.
[Fig. 14A] Fig. 14A is a diagram illustrating an image of the pin receiving member into which pins are inserted with respect to an insertion result when a magnet portion is implemented by connecting two magnets.
[Fig. 14B] Fig. 14B is a diagram illustrating an image of the pin receiving member into which pins are inserted with respect to an insertion result when the magnet portion is implemented by one magnet.
[Fig. 15] Fig. 15 is a diagram illustrating a pin insertion method used in a comparative example.

### Description of Embodiments

Hereinafter, several embodiments of the present invention will be described in detail with reference to the drawings. One of preferred embodiments of the present invention is shown in the drawings, and a part of the configuration in each embodiment may be changed, deleted, or added without departing from the gist of the present invention. Furthermore, the following description of one embodiment of the present invention may also be applied to other embodiments.

### [First Embodiment]

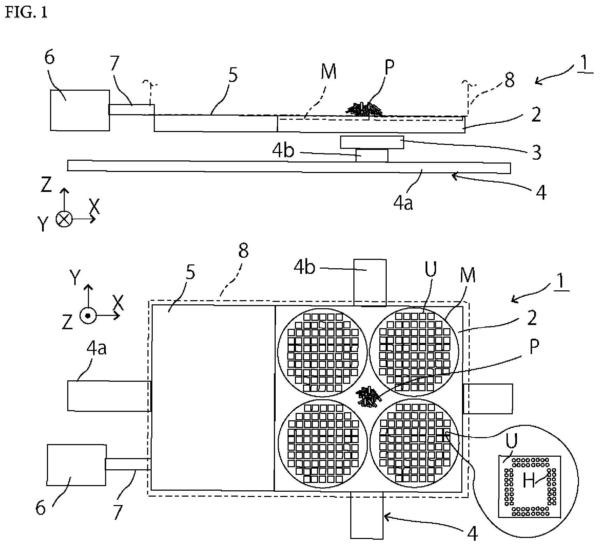

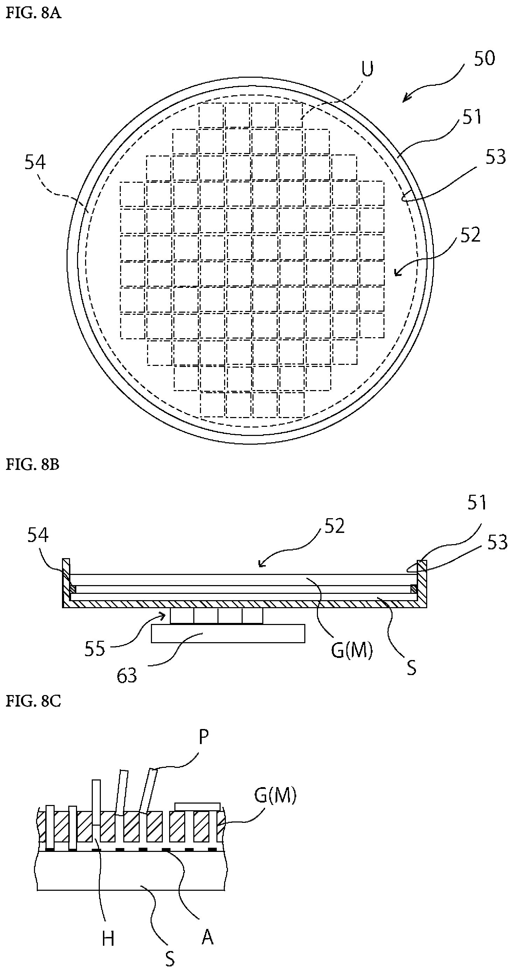

An outline of a pin control device according to a first embodiment of the present invention is illustrated in a side view in an upper part and in a plan view in a lower part in Fig. 1. A pin control device 1 includes a support portion 2 that supports a plurality of pin receiving members M, and a magnet portion 3 that is disposed below the support portion 2 and generates a magnetic field. The pin receiving member M has a flat plate shape and has a plurality of insertion portions H that are through holes or non-through holes. As illustrated in a partially enlarged view of one pin receiving member M by a balloon in a plan view, the pin receiving member M includes a plurality of units U, and each units U has insertion portions H arranged side by side in an X-axis direction and a Y-axis direction to form a rectangular ring. Such a rectangular ring can be called an insertion area region. The pin receiving member M may include only one unit U, may include a plurality of units U in both the X-axis direction and the Y-axis direction in a planar shape as illustrated in Fig. 8A, or may include a plurality of units U in either the X-axis direction or the Y-axis direction. The pin receiving member M illustrated in Fig. 1 has a circular shape in a plan view, and may have a rectangular shape in a plan view. The support portion 2 supports four pin receiving members M in the illustrated embodiment, and the number of pin receiving members M is not limited to that illustrated in Fig. 1, and at least one pin receiving member M can also be applied.

As illustrated in Fig. 1, the magnet portion 3 is disposed below the support portion 2 and is disposed on a movement means 4 that is slidable along one or more flat plate-shaped pin receiving members M. The magnet portion 3 generates a magnetic field so as to intersect an upper surface of the pin receiving member M, preferably, so as to be substantially perpendicular to the insertion portions H. For example, the magnet portion 3 may be implemented by one permanent magnet, or may be implemented by a plurality of permanent magnets as in an embodiment to be described later. In addition, the magnet portion 3 may be implemented by a plurality of electromagnets as in the embodiment to be described later.

In the embodiment illustrated in Fig. 1, the movement means 4 is implemented by an X-Y stage including a rail 4a extending in the X-axis direction and a rail 4b extending in the Y-axis direction. The magnet portion 3 can be moved in both the X-axis direction and the Y-axis direction, and by simultaneously moving the magnet portion 3 in the X-axis direction and the Y-axis direction, the magnet portion 3 can also be moved obliquely in an XY plane with respect to the X-axis direction or the Y-axis direction or can also be moved so as to draw a circular arc or an elliptical arc. The movement means 4 may adjust a position of the magnet portion 3 in a Z-axis direction with respect to the pin receiving member M, or may have other configurations.

The pin control device 1 can change a posture and a position of at least a part of a plurality of pins P placed on the pin receiving member M by causing the magnet portion 3 to slide relative to the support portion 2, more specifically, the pin receiving member M, and can insert the pins P into the insertion portions H of the pin receiving member M. In the movement means 4, for example, the rails 4a and 4b have a predetermined length so that the magnet portion 3 can be slid over the entire region below the support portion 2 and the magnet portion 3 can be slid under a plate portion 5 to be described later.

In the pin control device 1, the plate portion 5 is preferably provided close to the pin receiving member M. The movement means 4 can cause the magnet portion 3 to slide from below the pin receiving member M to below the plate portion 5. Accordingly, it is possible to remove the remaining pins that remain on the pin receiving member M without being inserted into the insertion portion H. A suction device 6 is connected to the plate portion 5 by a suction pipe 7 or another connection unit, and the suction device 6 suctions the remaining pins present on the plate portion 5, so that the remaining pins can be completely removed from the plate portion 5. The suction pipe 7 or the other connection unit is connected to the plate portion 5 instead of the support portion 2 to suction the remaining pins, and thus an influence on the pins P inserted into the insertion portions H of the pin receiving member M is reduced as much as possible.

Here, the magnet portion 3 may be slidable along the pin receiving member M above the support portion 2 and the plate portion 5 instead of being slidable along the pin receiving member M below the support portion 2 and the plate portion 5. In any form, it is not excluded that a magnetic field generated in a magnet other than the magnet portion 3 acts on the pin receiving member M. The plate portion 5 is preferably provided to form a substantially flush surface with an upper surface of the pin receiving member M. Here, "to form a substantially flush surface with an upper surface of the pin receiving member M" does not exclude a step between the upper surface of the pin receiving member M and an upper surface of the plate portion 5, and may be a configuration in which the pins P can move from at least the upper surface of the pin receiving member M to the upper surface of the plate portion 5. A side wall 8 is provided around the plate portion 5 and the support portion 2 so that the pins P do not fall outside from above the plate portion 5 and the support portion 2.

### [Second Embodiment]

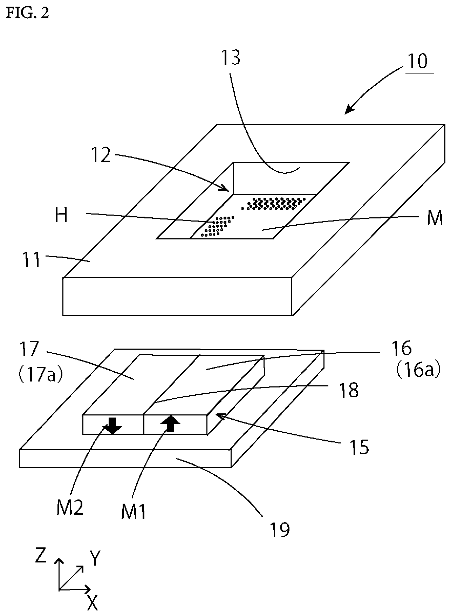

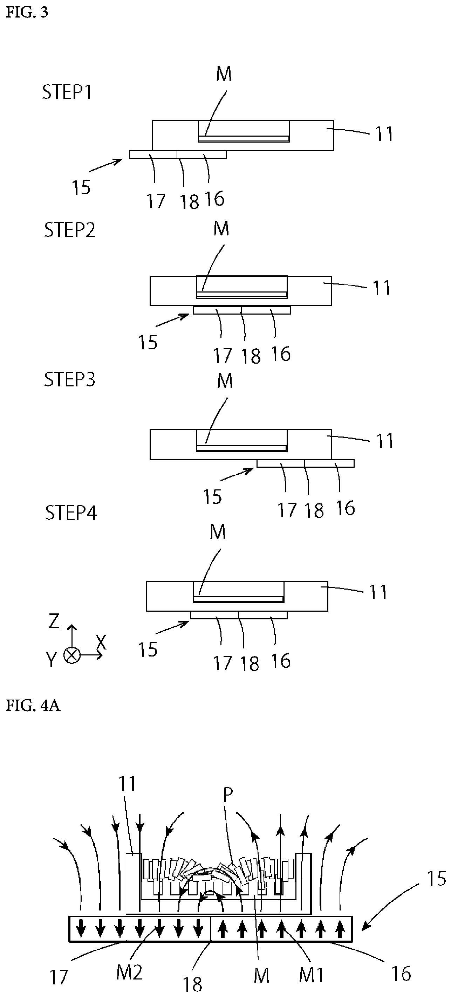

As a second embodiment of the present invention, a pin insertion device that can be applied to pin insertion in the pin control device 1 according to the first embodiment will be described. The pin insertion device 10 according to the second embodiment illustrated in Fig. 2 includes a support portion 11 and a magnet portion 15. The support portion 11 supports one or more flat plate-shaped pin receiving members M, and the pin receiving member M has a plurality of insertion portions H. The support portion 11 is configured such that an installation region 12 for installing the pin receiving members M is surrounded by a peripheral wall 13 in a circumferential shape such as a rectangular shape or a ring shape in front, rear, left, and right directions, and an upper surface side of the support portion 11 is opened so that the pins P (see Fig. 4A) can be input.

The magnet portion 15 is disposed below the pin receiving member M so as to be slidable along the pin receiving member M. The magnet portion 15 brings at least a first region 16 and a second region 17 close to each other, the first region 16 generates a magnetic field having a first orientation in a direction intersecting the pin receiving member M, and the second region 17 generates a magnetic field having a second orientation opposite to the first orientation in the direction intersecting the pin receiving member M. The magnetic fields are generated at least simultaneously in the first region 16 and the second region 17. The first region 16 is implemented by a first magnet 16a that generates the magnetic field having the first orientation, and the second region 17 is implemented by a second magnet 17a that generates the magnetic field having the second orientation. The first region 16 and the second region 17 are magnetized preferably in parallel along a depth direction (insertion direction of the pin P) of the insertion portion H in the center and in the vicinity thereof, and a magnetization orientation in the first region 16 is opposite to a magnetization orientation in the second region 17. In a case illustrated in Fig. 2, the first region 16 of the magnet portion 15 is magnetized in an arrow direction indicated by M1, and the second region 17 of the magnet portion 15 is magnetized in an arrow direction indicated by M2. The first region 16 and the second region 17 in the magnet portion 15 are juxtaposed at a boundary 18, and are close to or adjacent to each other in some cases. A non-magnetic material may be provided between the first region 16 and the second region 17. The same applies to other embodiments.

The magnet portion 15 can be moved in at least one direction (X-axis direction) by being disposed on, for example, an XY stage as a movement means 19, can also be moved not only in one direction but also, for example, within the XY plane, that is, in a direction inclined with respect to the X-axis direction or in a direction inclined with respect to the Y-axis direction, without changing a distance in the Z-axis direction from the pin receiving member M, and can be moved in any direction. In addition, the magnet portion 15 may be installed on a rotor so as to draw a circular arc or an elliptical arc. Accordingly, the magnet portion 15 can slide in parallel along a surface of the pin receiving member M.

Fig. 3 is a diagram illustrating a pin insertion method applied to the pin insertion device 10 illustrated in Fig. 2. In the pin insertion method, in STEP0 (not illustrated), one pin receiving member M is disposed in the installation region 12 of the support portion 11, and the pins P (not illustrated in Fig. 3) are input onto the pin receiving member M or into the opening on the upper surface side of the support portion 11. The number of pins P may be larger than the number of insertion portions H of the pin receiving member M.

Next, in STEP1, the magnet portion 15 is disposed on a side opposite to the pin receiving member M across the support portion 11. In the illustrated case, the boundary 18 and the second region 17 of the magnet portion 15 do not overlap the pin receiving member M in a plan view. At this time, it is not excluded that the first region 16 of the magnet portion 15 does not overlap the pin receiving member M. In this state, the magnet portion 15 is moved along the surface of the pin receiving member M by the movement means 19 (not illustrated in Fig. 3, see Fig. 2) such that the first region 16 and the second region 17 of the magnet portion 15 overlap the pin receiving member M in a plan view. This state is shown in STEP2.

In STEP2, the magnet portion 15 is subsequently moved along the surface of the pin receiving member M by the movement means 19 so that the first region 16 and the boundary 18 of the magnet portion 15 do not overlap the pin receiving member M in a plan view. This state is shown in STEP3. At this time, it is not excluded that the second region 17 of the magnet portion 15 does not overlap the pin receiving member M.

In STEP3, the magnet portion 15 is moved in an opposite direction along the surface of the pin receiving member M by the movement means 19 so that the first region 16 and the second region 17 of the magnet portion 15 overlap the pin receiving member M in a plan view. This state is shown in STEP4.

In STEP4, the magnet portion 15 is subsequently moved by the movement means 19 in the opposite direction along the surface of the pin receiving member M so that the boundary 18 and the second region 17 of the magnet portion 15 do not overlap the pin receiving member **M.** This state is shown in STEP1. At this time, it is not excluded that the first region 16 of the magnet portion 15 does not overlap the pin receiving member **M.**

In this way, an operation from STEP1 through STEP4 to STEP1 is repeated a predetermined number of times. Accordingly, the pins P are inserted into the insertion portions H. The reason for this will be described below.

Fig. 4A is a diagram illustrating magnetic field lines when the magnet portion 15 is implemented by a magnet having the first region 16 and the second region 17, and the magnetization orientations in the first region 16 and the second region 17 are opposite to each other. The same or corresponding members as those illustrated in Figs. 2 and 3 are denoted by the same reference numerals, and the description thereof will be omitted.

Magnetization M1 of the first region 16 and magnetization M2 of the second region 17 are along the direction of the insertion portion H, and thus the magnet portion 15 generates magnetic field lines upward from the first region 16 and the second region 17. Magnetization orientations are opposite to each other in the vicinity of the boundary 18 between the first region 16 and the second region 17, and thus the magnetic field lines are curved from one vicinity to the other vicinity in the vicinity of the boundary 18. Therefore, above the boundary 18, the pins P are parallel to a direction of the curved magnetic field lines, and thus the pins P above the boundary 18 intersect an up-down direction (depth direction) of the insertion portions H and are parallel to the surface of the pin receiving member M. In this way, the orientations of the pins P are not uniform in a standing direction and are inclined above the boundary 18, and thus the pins P are likely to be inserted into the insertion portions H by a magnetic force.

In the second embodiment of the present invention, by sliding the magnet portion 15 along the surface of the pin receiving member M, the boundary 18 slides, and the curved portion of the magnetic field lines slides, so that the posture of the pin P is changed due to the influence of the magnetic field in each insertion portion H. Therefore, for example, the posture of the pin P at a certain position can be changed form an upright state to a horizontal state to the upright state again. Accordingly, the pins P are inserted into the insertion portions H of the pin receiving member M. By sliding the magnet portion 15, the pin P at a certain position is moved in a direction in which the magnet portion 15 slides.

In Fig. 4A, the pin receiving member M and the support portion 11 are fixed and the magnet portion 15 slides, and the magnet portion 15 may be fixed and the pin receiving member M may slide, or the boundary 18 of the magnet portion 15 may slide with respect to the pin receiving member M by causing the support portion 11, the pin receiving member M, and the magnet portion 15 to slide. As described above, the boundary 18 between a region (first region 16 in Fig. 4A) in which the magnetic field having the first orientation is generated and a region (second region 17 in Fig. 4A) in which the magnetic field having the second orientation is generated is relatively moved along the surface of the pin receiving member M. Accordingly, the posture and the position of at least a part of the plurality of pins P placed on the pin receiving member M change, and a part of the plurality of pins P are inserted into the corresponding insertion portions H.

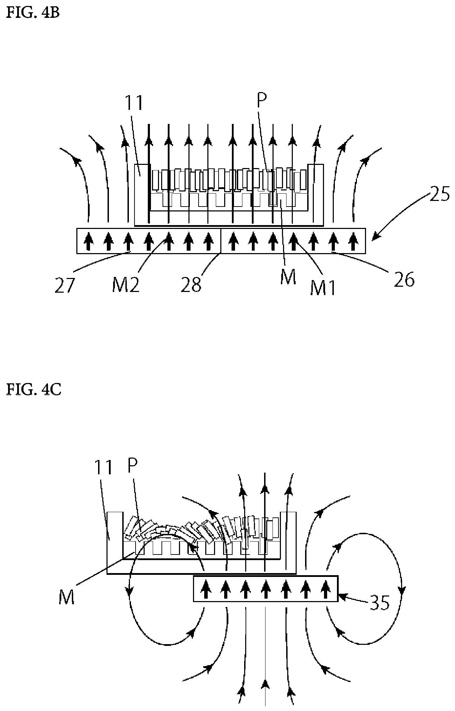

Fig. 4B is a diagram illustrating magnetic field lines when a magnet portion 25 is implemented by a magnet having a first region 26 and a second region 27, and magnetization orientations in the first region 26 and the second region 27 are the same according to a first comparative example. In the magnet portion 25, the first region 26 and the second region 27 are close to each other, both the first region 26 and the second region 27 are along the direction of the insertion portion H, and unlike Fig. 4A, the direction and the orientation of the magnetization M1 of the first region 26 are the same as the direction and the orientation of the magnetization M2 of the second region 27 in the magnet portion 25. The first region 26 and the second region 27 in the magnet portion 25 are juxtaposed at the boundary 28.

In such a form, as the magnetic field lines generated in the magnet portion 25 are schematically illustrated, the magnetic field lines intersect and are substantially orthogonal to the pin receiving member M on a pin receiving member M side of either the first region 26 or the second region 27 across the boundary 28. Therefore, if the influence of both ends of the magnet portion 25 is not taken into consideration, when the magnet portion 25 is slid in parallel along the surface of the pin receiving member M, the pins P also maintain an upright state along the orientation of the magnetic field. Therefore, even if the magnet portion 25 is slid, the posture of the pins P cannot be changed, the pins P are simply displaced while remaining in the upright state, and an efficiency of inserting the pins P into the insertion portions is not improved.

Fig. 4C is a diagram illustrating magnetic field lines when the magnet portion 35 is implemented by one magnet magnetized in one direction and in one orientation. The magnetic field lines coming out of an end portion of the magnet portion 35 return while drawing a relatively small loop, and thus a region for making the pins P horizontal is generated. However, a magnetic flux density at and in the vicinity of the end portion of the magnet portion 35 is lower than that at and in the vicinity of a boundary illustrated in Fig. 4A. Even if the magnet portion 35 is slid in parallel along the pin receiving member M, the posture change ends from the upright state (vertical state) to the horizontal state (lateral state), and thus the insertion efficiency is poor. Therefore, it is not preferable.

Here, in the embodiment illustrated in Figs. 2 and 3, the magnet portion 15 has the first region 16 formed of one magnet (for example, a permanent magnet) and the second region 17 formed of another magnet (for example, a permanent magnet), so that the first magnet and the second magnet are integrated together by attractive forces of respective different poles.

Conversely, in the embodiment illustrated in Figs. 2 and 3, the magnet portion 15 has the first region 16 and the second region 17 that are each formed of one magnet. In addition, the magnet portion 15 may have not only two regions but also three or more regions, and in that case, the magnetization orientations of both juxtaposed regions or close regions, that is, adjacent regions may be opposite to each other.

### [Effectiveness of Pins to be in Horizontal State]

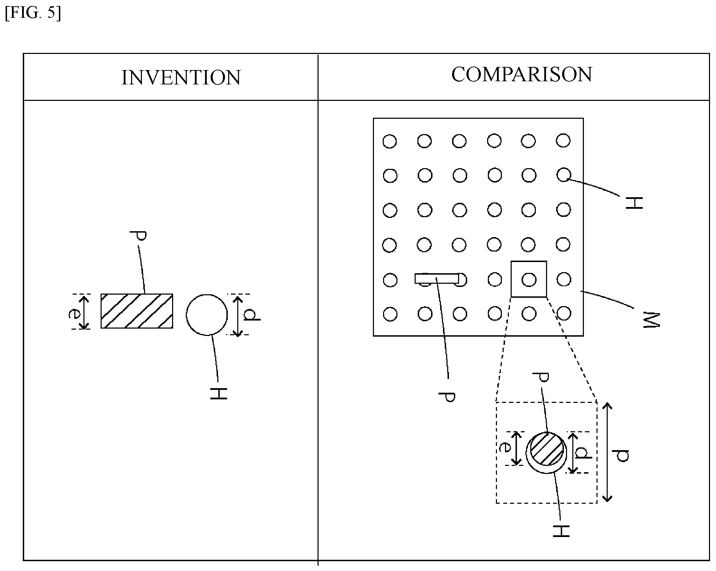

Here, an effectiveness of pin posture control will be examined. A difference in pin insertion efficiency between the embodiment illustrated in Fig. 4A and the embodiment illustrated in Fig. 4B will be considered. Fig. 5 is a diagram for examining a pin insertion probability. As illustrated in Fig. 5, the insertion portions H are arranged at equal intervals vertically and horizontally in a top view of a certain pin receiving member M. As illustrated in an enlarged manner on a right side in Fig. 5, focusing on one insertion portion H, a period of the insertion portion H is p, a diameter of the insertion portion H is d, and a diameter of the pin P is e. In the case in which the pin P is always upright as illustrated in Fig. 4B, a center (axis) of the pin P needs to be within a circle having a diameter of d - e centered on a center of the insertion portion H in order for the pin P to be inserted in one movement. Considering that the pin P randomly lands in a square of one side p, an insertion probability Q1 is Q1 = π {(d - e)/2}²/p² = π (d - e)²/4p²). As an example, when p = 0.4 mm, d = 0.2 mm, and e = 0.18 mm, Q1 = 0.196%.

On the other hand, as illustrated in Fig. 4A, in a case in which the pins P in the horizontal posture pass through one row of the insertion portions H, if a central axis of the pin P passes through a center of a hole by a width of d - e, the pin P is caught in the hole, and thus the probability is Q2 = (d - e)/p. When a numerical example of the previous example is used, Q = 5.0%, which is 25 times Q1.

Of course, in order to calculate an accurate insertion probability, it is necessary to consider the number of times of trial, but it is necessary to estimate the number of times of vibration in Q1 and the number of times of passing of the magnet in Q2. However, it is not considered that these numbers of times differ by 10 times, and it is presumed that a difference in probability of 25 times indicates a superiority in that the pin can be in the horizontal state.

### [Relation Between Arrangement of Insertion Portions H and Dimensions of Magnet Portion 15 in Plan View]

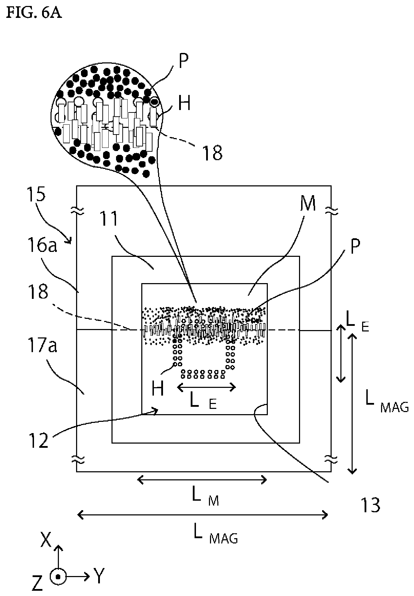

Fig. 6A is a plan view illustrating a first example of a relation between an arrangement state of the insertion portions H of the pin receiving member M and dimensions of the magnet portion 15 in a plan view. The magnet portion 15 is configured such that a first magnet 16a and a second magnet 17a are arranged side by side so as to be able to face the surface of the pin receiving member M, the first magnet 16a has the same vertical and horizontal dimensions and the same thickness as the second magnet 17a, and one side of the first magnet 16a and the second magnet in a plan view has a length L_{MAG}. On the other hand, it is assumed that the insertion portions H in the pin receiving member M having one square-shaped side L_{M} in a plan view are provided in a ring portion that forms a rectangular shape like a ring in a plan view by being arranged side by side in a plurality of rows along the X-axis direction and in a plurality of columns along the Y-axis direction, the ring portion has the same vertical and horizontal dimensions in a plan view, and one side of an insertion area region as the ring portion has a length L_{E}. Then, the dimension of the magnet portion 15 in a plan view becomes L_{MAG} × 2L_{MAG}, and a relation between the arrangement of the insertion portions H or the pin receiving member M and the dimensions of the magnet portion 15 (first magnet 16a or second magnet 17a) in a plan view satisfies a relation of L_{E} < L_{M} < L_{MAG} in the first example, and L_{E} ≈ 15 mm, L_{M} = 30 mm, L_{MAG} = 60 mm in a verification example to be described later.

As illustrated in Fig. 6A, the pin receiving member M is disposed in the installation region 12 of the support portion 11, and the magnet portion 15 is slidably installed below the support portion 11, that is, below the pin receiving member M along the pin receiving member M. Above and in the vicinity of the boundary 18 between the first magnet 16a and the second magnet 17a in the magnet portion 15, the pins P are in a state of being parallel to the pin receiving member M (horizontal state or lateral state), and the pins P in the parallel state are present over the left and right peripheral walls 13. Otherwise, the pins P are in a state of standing on the pin receiving member M (upright state or vertical state), and the pins P in the standing state are present over the left and right peripheral walls 13. As enlarged by a balloon in Fig. 6A, the pins P in the upright state are indicated by black circles, and the pins in the lateral state are indicated by elongated rectangles.

The boundary 18 between the first magnet 16a and the second magnet 17a reciprocates in an arrangement direction of the magnets by reciprocating the magnet portion 15 along the arrangement direction (X-axis direction) of the first magnet 16a and the second magnet 17a. In the first example, the pins P are not substantially orthogonal to the pin receiving member M, and a magnetic field is curved above the boundary 18, and thus as the boundary 18 moves, a posture state of the pins P above the boundary 18 changes, and the pins P are inserted into the insertion portions H.

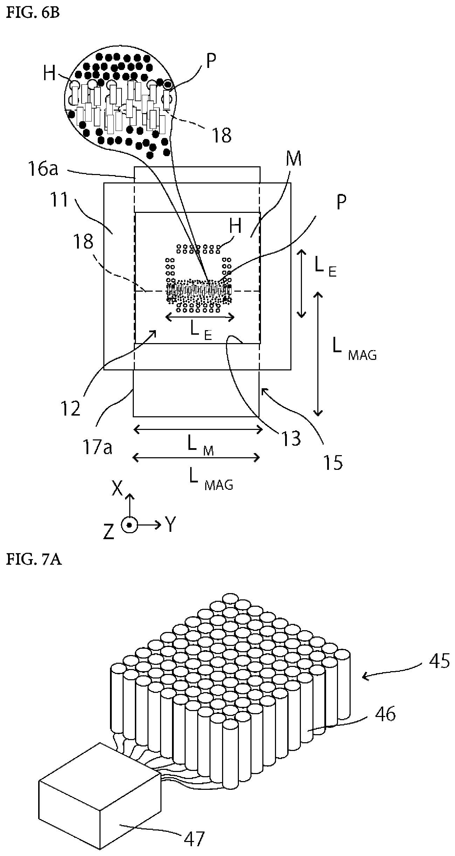

Fig. 6B is a plan view illustrating a second example of a relation between an arrangement state of the insertion portions H of the pin receiving member M and dimensions of the magnet portion 15 in a plan view. A configuration or a positional relation of the pin receiving member M, the support portion 11, and the magnet portion 15 are the same as those in Fig. 6A, but unlike the first example, the relation between the arrangement of the insertion portions H or the pin receiving member M and the dimensions of the magnet portion 15 (first magnet 16a or second magnet 17a) in a plan view satisfies a relation of L_{E} < L_{M} ≈ L_{MAG} in the second example, and L_{E} ≈ 15 mm, L_{M} = 30 mm, and L_{MAG} = 30 mm in a verification example to be described later.

As illustrated in Fig. 6B, above and in the vicinity of the boundary 18 between the first magnet 16a and the second magnet 17a of the magnet portion 15, the pins P are parallel to the pin receiving member M (horizontal state or lateral state) only inside the length L_{MAG} of one side of the first magnet 16a and the second magnet 17a of the magnet portion 15. The magnetic field is curved at edges of the first magnet 16a and the second magnet 17a in a direction (Y-axis direction) orthogonal to a sliding direction (see Fig. 4A), and thus the pins P move in a curved direction. As will be described later in the verification example, in the second example, when the pins P are placed so as to spread over the entire installation region 12 of the support portion 11, the pins P also move to the inside of the magnet portion 15 and do not spread out in the Y-axis direction of the magnet portion 15.

The boundary 18 between the first magnet 16a and the second magnet 17a reciprocates in the arrangement direction of the magnets by reciprocating the magnet portion 15 along the arrangement direction of the first magnet 16a and the second magnet 17a. In the second example, the posture of the pins P also changes by the magnetic field generated at the edges of the first magnet 16a and the second magnet 17a in the direction orthogonal to the sliding direction, and the pins P are also inserted into the insertion portions H. The dimensions of the first magnet 16a and the second magnet 17a constituting the magnet portion 15 in a direction (Y-axis direction) orthogonal to the arrangement direction of the magnets are determined in relation to one side of the pin receiving member M or one side of a region in which the insertion portion H is present. Accordingly, the pin P can be confined only inside the region in which the insertion portion H is present, and a region in which the pin P on the pin receiving member M is present can be regulated.

The relation between the arrangement of the insertion portions H and the dimensions of the magnet portion 15 in a plan view is effective when a relation between one side L_{E} (mm) of the insertion area region in which the insertion portions H are arranged and the dimension L_{MAG} (mm) of the magnet portion 15 in a plan view satisfies a relation of L_{MAG} - 20 ≤ L_{E} ≤ L_{MAG} - 2. The second example is applied not only to a case in which the insertion portions H are present in a rectangular shape in a plan view in one pin receiving member M as illustrated in Fig. 6B, but also to a case in which there are individually divided regions (units U illustrated in Fig. 8A to be described later) in one pin receiving member M, and the insertion portions H are present in a rectangular shape in a plan view in the X-axis direction and the Y-axis direction for each region. Here, L_{E} is a length of one side of the insertion area region in the individually divided region.

### [Sliding Speed of Pin Receiving Member M and Magnet Portion 15]

A relative sliding speed between the pin receiving member M and the magnet portion 15 may also depend on the dimensions of the pin P and the dimensions of the magnet portion 15. When the relative sliding speed is high, the magnetic field in the vicinity of the boundary 18 between the first magnet 16a and the second magnet 17a acting on the pin P may not cause the pin P to change the posture. Therefore, the relative sliding speed between the pin receiving member M and the magnet portion 15 is determined by the length and weight of the pin P, the length L_{M} of one side of the first magnet 16a and the second magnet 17a of the magnet portion 15, and a distance between the magnet portion 15 and the pin receiving member M, and is particularly determined by the length L_{MAG} of one side of the first magnet 16a and the second magnet 17a of the magnet portion 15.

Specifically, the relative sliding speed between the pin receiving member M and the magnet portion 15 is preferably 400 mm/sec or less, and more preferably 200 mm/sec or less. This is because the pins P are not inserted into all the insertion portions H at a sliding speed higher than the above sliding speed. When the length L_{MAG} of one side of the first magnet 16a and the second magnet 17a is 30 mm, the sliding speed may be 400 mm/sec or less, and when the length L_{M} of one side of the first magnet 16a and the second magnet 17a is 60 mm, the sliding speed may be 200 mm/sec or less.

### [Third Embodiment]

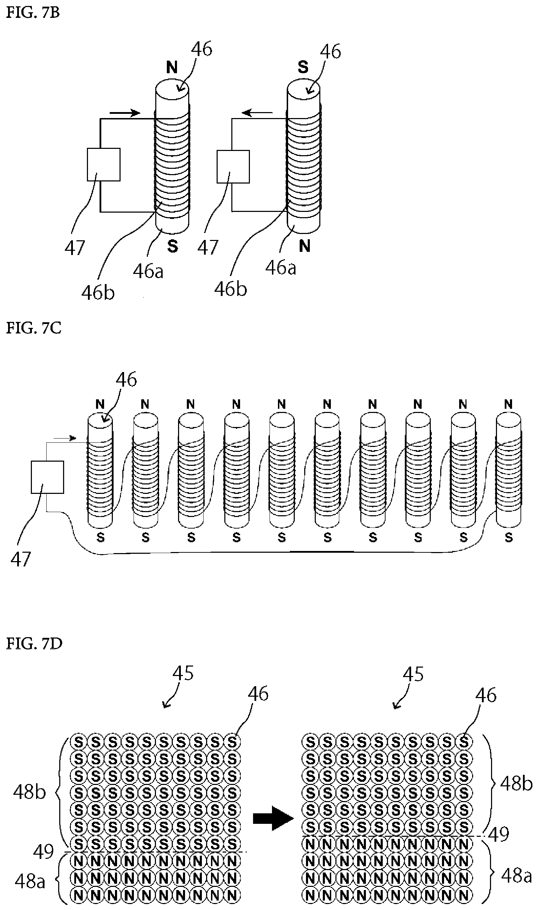

As a third embodiment of the present invention, a pin insertion device that can be applied to pin insertion in the pin control device 1 will be described. Fig. 7A is a diagram schematically illustrating a configuration of a magnet portion in the pin insertion device according to the third embodiment of the present invention, Fig. 7B is a diagram illustrating a use mode of one of electromagnets illustrated in Fig. 7A, Fig. 7C is a diagram illustrating one column or one row of electromagnets in the magnet portion illustrated in Fig. 7A, and Fig. 7D is a diagram schematically illustrating a change in a magnetic field generated in the magnet portion illustrated in Fig. 7A.

The pin insertion device according to the third embodiment of the present invention includes the support portion 11 (see Fig. 2) and a magnet portion 45, and the magnet portion 45 includes a plurality of electromagnets 46 arranged in an array as illustrated in Fig. 7A. Each electromagnet 46 constitutes a solenoid by providing a winding 46b around an air-core or a magnetic core 46a. The winding 46b is connected to a circuit unit 47, and an orientation and a magnitude of a current flowing through the electromagnet 46 can be controlled by the circuit unit 47. Accordingly, as illustrated in the left and right in Fig. 7B, a pole of the electromagnet 46 can be reversed. The electromagnets 46 are arranged in an array, and as illustrated in Fig. 7C, the plurality of electromagnets 46 are connected in series to form one row or one column of the magnet portions 45.

By controlling an orientation and a magnitude of a current flowing through the electromagnets 46 by the circuit unit 47, it is possible to move a boundary 49 between regions 48a in which a magnetic field having a first orientation is generated and regions 48b in which a magnetic field having a second orientation is generated in the magnet portions 45, as illustrated in Fig. 7D.

In this way, in the third embodiment, the boundary 49 can be reciprocated in a direction perpendicular to the boundary 49 by controlling the current flowing through the electromagnets 46 by the circuit unit 47 without moving the magnet portion 15 or the pin receiving member M as in the second embodiment, and the boundary 49 between the regions 48a in which the magnetic field having the first orientation is generated and the regions 48b in which the magnetic field having the second orientation is generated can be moved along the surface of the pin receiving member M as in the second embodiment. Therefore, a posture of at least a part of the plurality of pins P placed on the pin receiving member M changes, and a part of the plurality of pins P are inserted into the corresponding insertion portions H.

An arrangement region and dimensions of the electromagnets 46 in the magnet portion 45, a relative sliding speed between the pin receiving member M and the boundary 49, and the like are changed as necessary in accordance with the second embodiment.

The third embodiment of the present invention can be applied not only to the pin insertion device that can be applied to the pin insertion in the pin control device 1, but also to the remaining pin removal by disposing the electromagnets below the plate portion 5 in the pin control device 1 and causing a current to flow when removing the remaining pins. At this time, it is possible to demagnetize the magnetized electromagnets 46 by causing a current having an orientation in which the magnetized electromagnets 46 are magnetized in the opposite direction to flow for a short time.

### [Fourth Embodiment]

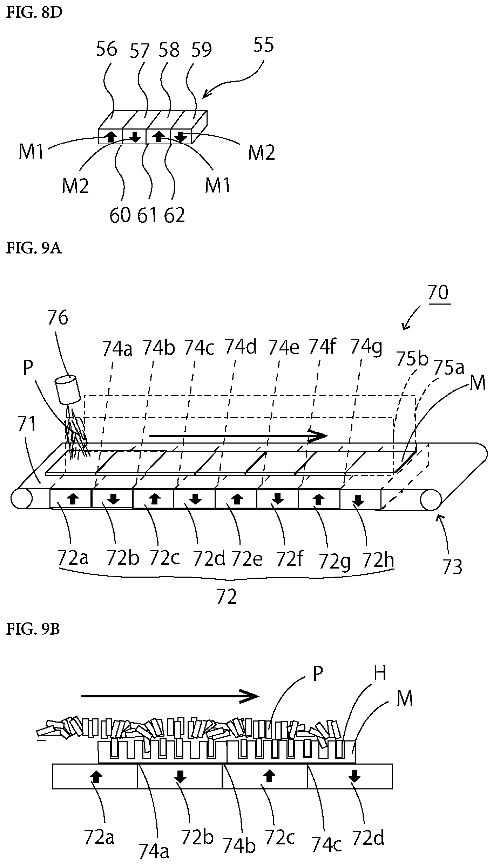

As a fourth embodiment of the present invention, a pin insertion device that can be applied to pin insertion in the pin control device 1 will be described. Fig. 8A is a plan view illustrating an outline of the pin insertion device according to the fourth embodiment of the present invention, Fig. 8B is a partial sectional view illustrating an outline of the pin insertion device according to the fourth embodiment of the present invention, Fig. 8C is a partially enlarged view of Fig. 8B, and Fig. 8D is a schematic diagram of a magnet portion illustrated in Fig. 8B.

A pin insertion device 50 according to the fourth embodiment includes a support portion 51 and a magnet portion 55. The support portion 51 supports one flat plate-shaped pin receiving member M, and the pin receiving member M has a plurality of insertion portions H.

The support portion 51 is configured such that an installation region 52 for installing one flat plate-shaped substrate S and a guide member G as one flat plate-shaped pin receiving member M is surrounded by a circumferential peripheral wall 53, an upper surface side of the support portion 51 is opened, the substrate S is placed on the support portion 51, for example, an annular spacer 54 along the peripheral wall 53 is disposed, the pin receiving member M is placed thereon, and a large number of pins P are input onto the pin receiving member M. Here, as illustrated in Fig. 8A, the guide member G as the pin receiving member M supported by the support portion 51 includes a plurality of insertion portions H. The substrate S is placed on the support portion 51 below the guide member G. The substrate S is a semiconductor substrate having a large diameter such as 12 inches, and a plurality of basic units U constituting one chip are arranged vertically and horizontally. A bonding material A such as solder is provided in a predetermined pattern on a surface of the basic unit. The guide member G has through holes as insertion portions H in the same manner as the predetermined pattern of the bonding material A, and a large number of pins P input onto the guide member G are inserted into the insertion portions H.

The magnet portion 55 is disposed to be slidable along the pin receiving member M. In the illustrated embodiment, the magnet portion 55 includes a first region 56, a second region 57, a third region 58, and a fourth region 59 that are continuously adjacent to one another in this order, the first region 56, the second region 57, the third region 58, and the fourth region 59 are magnetized so as to intersect (preferably, orthogonal to) the pin receiving member M, that is, are magnetized preferably in parallel along the depth direction of the insertion portion H (insertion direction of the pin P), and the magnetization orientation in the first region 56 and the magnetization orientation in the third region 58 are opposite to the magnetization orientation in the second region 57 and the magnetization orientation in the fourth region 59. The first region 56 and the third region 58 of the magnet portion 55 are magnetized in the arrow direction indicated by M1, and the second region 57 and the fourth region 59 of the magnet portion 55 are magnetized in the arrow direction indicated by M2. The first region 56 and the second region 57 of the magnet portion 55 are in contact with each other at a boundary 60, the second region 57 and the third region 58 of the magnet portion 55 are in contact with each other at a boundary 61, and the third region 58 and the fourth region 59 of the magnet portion 55 are in contact with each other at a boundary 62. A non-magnetic material may be provided between the regions.

The magnet portion 55 can be moved in a plurality of directions parallel to the surface of the pin receiving member M in the X-axis direction and the Y-axis direction by being disposed on, for example, an XY stage as a movement means 63, and the magnet portion 55 can be moved obliquely with respect to the X-axis direction or the Y-axis direction in the XY plane or can be moved so as to draw a circular arc or an elliptical arc by being moved simultaneously in the X-axis direction and the Y-axis direction. The movement means 63 may be installed on a rotor so as to draw a circular motion as well as a linear motion. Accordingly, the magnet portion 65 can slide in parallel along a surface of the guide member G as the pin receiving member M.

In this way, the magnet portion 55 slides by the movement means 63, and thus the pins P are inserted into the insertion portions H and erected on the bonding material A as described in detail in each of the above embodiments. Thereafter, the guide member G and the substrate S are taken out and placed in a furnace as they are, and a weight (not illustrated) is placed on the guide member G as necessary and heated for a certain time. Accordingly, the substrate S and the pins P are bonded by the bonding material **A.**

The first region 56, the second region 57, the third region 58, and the fourth region 59 of the magnet portion 55 can be set such that dimensions in a direction orthogonal to an arrangement direction of the first region 56 to the fourth region 59 extend over the plurality of basic units U. This is because the pins P can be inserted into the insertion portions H of the guide member G above the plurality of basic units U by reciprocating the magnet portion 55 in the arrangement direction of the regions with the movement means 63.

### [Fifth Embodiment]

As a fifth embodiment of the present invention, a pin insertion device that can be applied to pin insertion in the pin control device 1 will be described. Fig. 9A is a perspective view schematically illustrating a pin insertion device 70 according to the fifth embodiment of the present invention, and Fig. 9B is a diagram illustrating a main part of the pin insertion device 70. The pin insertion device 70 according to the fifth embodiment includes a support portion 71, a magnet portion 72, and a movement means 73.

The support portion 71 supports a flat plate-shaped pin receiving member M, and the pin receiving member M has a plurality of insertion portions H (not illustrated in Fig. 9A). The movement means 73 includes a mechanism that moves the support portion 71 in a certain direction, and can cause the pin receiving member M on the support portion 71 to move in a certain direction by, for example, stretching and rotating the support portion 71 having an endless shape with rotation shafts on both sides as illustrated in Fig. 9A. The pin receiving member M is placed from one end side of the support portion 71, moves in a certain direction, and is pushed out on the other end side.

The magnet portion 72 is provided between the upper support portion 71 on which the pin receiving member M is placed and moves and the lower support portion on which the pin receiving member M returns. In the magnet portion 72, a first magnet 72a, a second magnet 72b, a third magnet 72c, a fourth magnet 72d, a fifth magnet 72e, a sixth magnet 72f, a seventh magnet 72g, and an eighth magnet 72h are arranged side by side in this order in a flowing direction of the pin receiving member M. All of the first magnet 72a to the seventh magnet 72g simultaneously generate magnetic fields so as to intersect, preferably orthogonal to, the pin receiving member M, the first magnet 72a, the third magnet 72c, the fifth magnet 72e, and the seventh magnet 72g are magnetized upward, and the second magnet 72b, the fourth magnet 72d, the sixth magnet 72f, and the eighth magnet 72h are magnetized downward. In this way, the close magnets in the magnet portion 72 are magnetized in opposite orientations. Here, a first boundary 74a between the first magnet 72a and the second magnet 72b, a second boundary 74b between the second magnet 72b and the third magnet 72c, a third boundary 74c between the third magnet 72c and the fourth magnet 72d, a fourth boundary 74d between the fourth magnet 72d and the fifth magnet 72e, a fifth boundary 74e between the fifth magnet 72e and the sixth magnet 72f, a sixth boundary 74f between the sixth magnet 72f and the seventh magnet 72g, and a seventh boundary 74g between the seventh magnet 72g and the eighth magnet 72h can all face the pin receiving member M.

A pair of guide plates 75a and 75b are disposed above the support portion 71 on a side orthogonal to a movement direction of the pin receiving member M so as to sandwich a region on which the pin receiving member M is placed. In addition, a pin supply box 76 is provided above the support portion 71, at least above on which the pin receiving member M is placed. The pins P are input from the pin supply box 76 toward the pin receiving member M. The guide plates 75a and 75b prevent the pins P from being detached from the pin receiving member M. The pin receiving member M is moved in an arrow direction in Fig. 9A by the movement means 73, and thus the pin supply box 76 may be disposed such that the pins P are input onto the moved pin receiving member M. Further, the pins P may be inclined so as to roll on the plurality of arranged pin receiving members M.

In the pin insertion device 70, one pin receiving member M is moved in an arrow direction illustrated in Fig. 9B by the movement means 73. Accordingly, a part of the plurality of pins P placed on the pin receiving member M are changed from an upright state to a horizontal state and then to an upright state before and after the first boundary 74a, thereby being inserted into the insertion portions H of the pin receiving member M. The rest of the plurality of pins P supplied from the pin supply box 76 and placed on the pin receiving member M is placed on the pin receiving member M above the magnet portion 72 and moved by the movement means 73. Hereinafter, similarly, a part of the plurality of pins P placed on the pin receiving member M are changed from an upright state to a horizontal state and then to an upright state before and after each boundary between the second boundary 74b to the seventh boundary 74g, thereby being inserted into the insertion portions H of the pin receiving member M. The rest of the plurality of pins P is placed on the pin receiving member M above the magnet portion 72 and moved by the movement means 73.

In the fifth embodiment, the magnet portion 15 does not reciprocate as in the second embodiment, and thus there is an advantage that a tact time is shortened. In the second embodiment, the magnet portion 15 is slid back and forth, and thus if a tact time t is, for example, 5 seconds, in the fifth embodiment, it takes 5 seconds for the pin insertion members M to pass through during which time 7 pin insertion members M are conveyed out. Therefore, the tact time can be shortened to about 0.7 seconds. In this way, when a plurality of magnets are arranged in one direction to generate magnetic fields in a direction intersecting, preferably orthogonal to, the pin receiving member M, and the magnetic fields generated in the close magnets have opposite orientations in the magnet portion 72, the tact time is shortened according to the number of magnets of the magnet portion 72 (more accurately, according to the number of times the pin receiving member M passes through the boundary between the magnets).

The sliding speed of the pin receiving member M with respect to the magnet portion 72 is set in the same manner as in the second embodiment.

### [Sixth Embodiment]

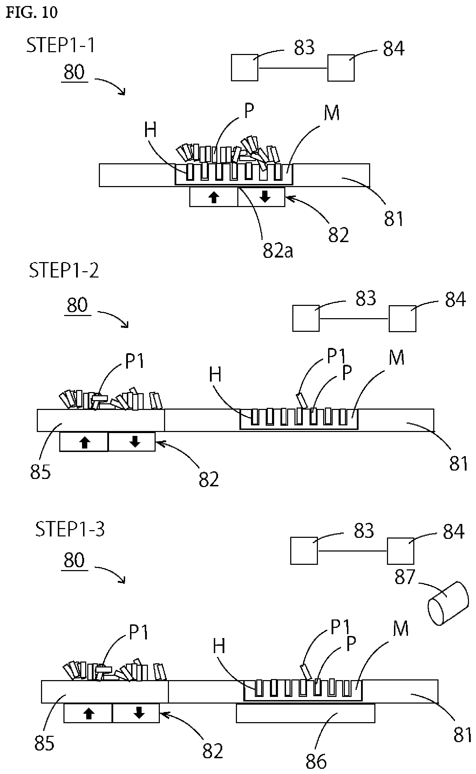

As a sixth embodiment of the present invention, a remaining pin removal method that can applied to remaining pin removal in the pin control device 1 will be described. Fig. 10 is a diagram illustrating a remaining pin removal step performed by a remaining pin removal device 80 according to the sixth embodiment of the present invention.

According to the above embodiments, as shown by STEP1-1, a large number of pins P are input onto the pin receiving member M, the magnet portion 82 is relatively moved along the surface of the pin receiving member M, and the pins P are inserted into the insertion portions H of the pin receiving member M. One pin receiving member M is supported by the support portion 81 in Fig. 10, and a plurality of pin receiving members M may be arranged in a row or on a surface.

For example, a state in which the pins P are inserted into the insertion portions H above the pin receiving member M is imaged by a camera 83, image data from the camera 83 is analyzed by an analysis unit 84, and a pin insertion rate is calculated. When the pin insertion rate does not reach a predetermined percentage, for example, 100%, the image data is analyzed, it is determined into which insertion portion H no pin P is inserted, a boundary 82a between close magnets in the magnet portion 82 is moved below and in the vicinity of the insertion portions H into which no pin P is inserted, and the magnet portion 82 is slid back and forth in the arrangement direction of the close magnets. Accordingly, the image is captured by the camera 83, the image data is analyzed, and the pin insertion rate is calculated again, so that it is determined whether the pin insertion rate has reached the predetermined percentage. If the pin insertion rate does not reach the predetermined percentage, the boundary 82a between the close magnets in the magnet portion 82 is moved to below and in the vicinity of the insertion portions H into which no pin P is inserted, and the magnet portion 82 is slid back and forth in the arrangement direction of the close magnets again.

When it is confirmed that the pin insertion rate has reached the predetermined percentage, the pin receiving member M and the support portion 81 are moved to bring the plate portion 85 close to the pin receiving member M and the support portion 81, or as shown in STEP1-2, the plate portion 85 is brought into a state of being disposed close to the pin receiving member M in advance as illustrated in the first embodiment, and the magnet portion 82 is moved from below the pin receiving member M to below the plate portion 85. Accordingly, the remaining pins P1 that remain on the pin receiving member M are moved from the pin receiving member M to the plate portion 85.

The camera 83 images the pin receiving member M, and the analysis unit 84 confirms whether the pin P1 remains on the pin receiving member M.

When the pin P1 remains on the pin receiving member M, as shown in STEP1-3, another magnet portion 86 that generates a magnetic field weaker than the magnetic field generated in the magnet portion 82 is disposed below the pin receiving member M, and air is blown to the pin receiving member M by a blower 87 to completely remove the remaining pins P1. For example, a C-shaped magnet is used as the other magnet portion 86 to generate a magnetic field in a predetermined direction only in a gap of C, making it easy to control. Here, when air is blown by the blower 87, the magnet portion 82 may be used without using the other magnet portion 86. The other magnet portion 86 or the magnet portion 82 applies a magnetic field to the insertion portions H, which prevents the pins P inserted into the insertion portions H from flying out due to the air blown by the blower 87.

### [Pins and Pin receiving member]

In the present specification, a flat plate-shaped member having insertion portions H into which pins are to be inserted is referred to as a "pin receiving member" M, and examples of the pin receiving member include a "substrate" in a certain embodiment, specifically, a "semiconductor substrate" having one or more electronic devices. In another embodiment, a "guide member" having a plurality of through holes is exemplified, and in this case, the guide member is disposed apart from the semiconductor substrate on which one or more electronic devices are constructed, a plurality of pins are placed on the guide member, and the pins are inserted into the through holes of the guide member to erect on the semiconductor substrate. The pin receiving member has through holes or non-through holes as a plurality of insertion portions in a predetermined pattern. Here, there is a case in which the substrate is diced and configured as one chip by a post-process such as molding. Therefore, there is a case in which a plurality of basic units each constituting one chip are arranged side by side on the substrate. The pin to be inserted into the insertion portion has a micro size that is assumed to be a size of 1 µm or more and 1000 µm or less. The pin is preferably a pin having no flange portion (flangeless pin) or a pin having no head portion (headless pin), is, for example, a rod shape (columnar shape) such as a columnar shape, and has a diameter of 1 µm or more and 1000 µm or less and a length of 1 µm or more and 1000 µm or less. Therefore, one pin has an extremely small mass, and it is difficult to apply a force from the pin to the outside by a weight of the pin. The pin contains a material that interacts with the magnet.

### [Verification Example 1]

A verification example related to the concept of the present invention will be described. As illustrated in Fig. 2, the flat plate-shaped pin receiving member M was disposed in the installation region 12 in the support portion 11. The pin receiving member M is provided with five vertical rows and five horizontal rows of holes as the insertion portions H in a rectangular shape surrounding a central portion. A large number of pins P were put into the installation region 12 in the support portion 11. The magnet portion 15 was disposed below the support portion 11, and slid back and forth in parallel along the pin receiving member M. The number of times of reciprocation was 5. The pin P had a cylindrical shape with a diameter of 0.2 mm and a length of 0.4 mm. The pin receiving member M had a plate shape of 29 mm × 29 mm × 0.5 mm in thickness, had holes as the insertion portions H having a diameter of 0.205 mm, the hole had a depth of 0.35 mm, and the number of holes was 527. The number of input pins P was about 7000.

The magnet portion 15 used in Verification Example 1 was implemented by preparing two flat plate-shaped magnets of 30 mm × 30 mm × 5 mm and bonding end portions of the respective magnets by an attractive force of the magnets. Therefore, the magnet portion has a flat plate shape of 60 mm × 30 mm × 5 mm.

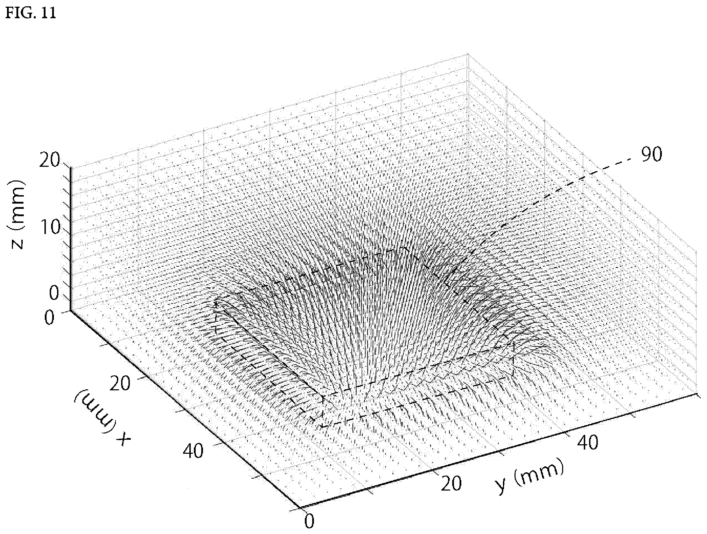

Fig. 11 is a diagram illustrating results obtained by measuring a magnetic flux density of one magnet used. A magnetic probe was used for the measurement. The magnetic flux density was measured by changing a position of the magnetic probe every 2 mm. One magnet 90 is indicated by a virtual line. It was found that a magnetic flux in the X-axis direction is strong at each end of the magnet 90 in an X-axis direction, a magnetic flux in the Y-axis direction is strong at each end of the magnet 90 in a Y-axis direction, and a magnetic flux in the Z-axis direction is strong at a portion excluding both ends in the X-axis direction and each end in the Y-axis direction of the magnet 90.

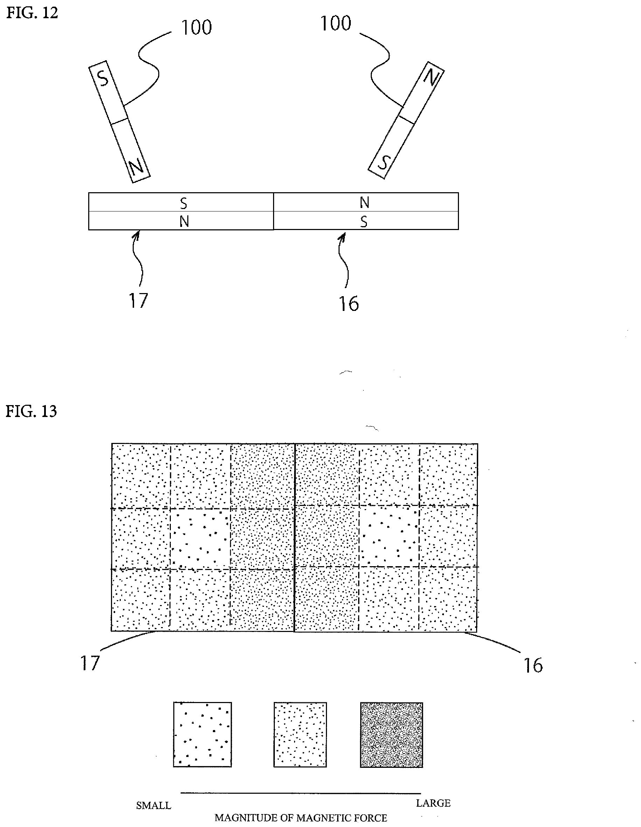

As illustrated in Fig. 12, a polarity of the magnet was determined by bringing ends of rod magnets 100 closer to each other and checking which of an attractive force and a repulsive force acted. The magnetic poles of the magnet portions connected as a pair were confirmed as follows. Each of the first region 16 and the second region 17 on the upper surface of the magnet portion 15 was divided into three rows and three columns, one pole of the rod magnet was brought close to the divided portions, and a strength of a magnetic force in the divided portions was confirmed.

Fig. 13 is a diagram schematically illustrating the strength of the magnetic force in the divided portions of the used magnet portion. The magnetic force is largest in the divided portions on both sides sandwiching the boundary between the first region 16 and the second region 17, and is second largest in the divided portions on sides opposite to the boundary between the first region 16 and the second region 17. An intermediate portion of one side intersecting the boundary between the first region 16 and the second region 17 was continuously large, and a central portion of each of the first region 16 and the second region 17 was the smallest. The magnets constituting the first region 16 and the second region 17 were the same, the magnetic force was substantially the same in the divided portions forming the periphery of the magnet, and the magnetic force was low in the center of the magnet.

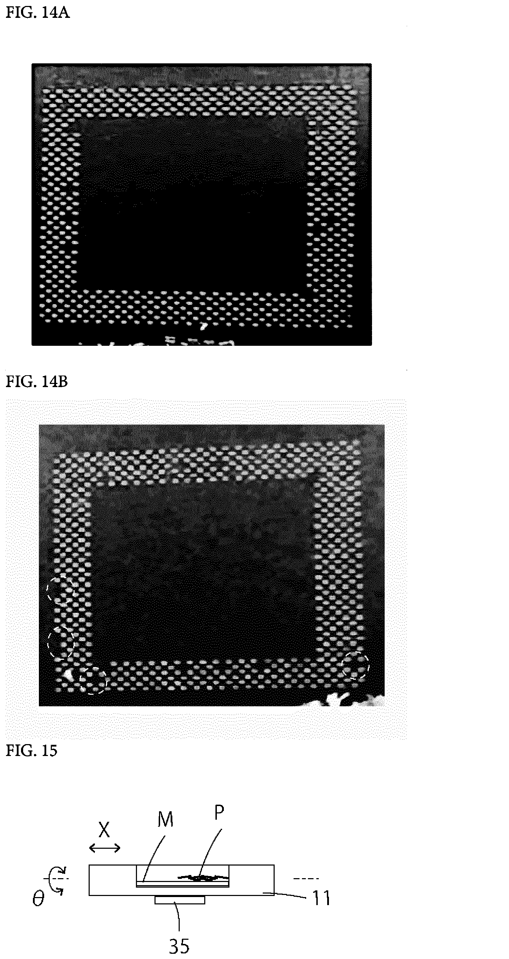

Fig. 14A is a diagram illustrating an image of the pin receiving member M into which the pins P are inserted with respect to an insertion result when the magnet portion 15 is implemented by connecting two magnets. Fig. 14B is a diagram illustrating an image of the pin receiving member M into which the pins P are inserted with respect to an insertion result when the magnet portion 15 is implemented by one magnet. As illustrated in Fig. 14A, when the magnet portion 15 is implemented by connecting two magnets, the pins P are inserted into all the insertion portions H, and the insertion operation is completed in about 5 seconds. On the other hand, as illustrated in Fig. 14B, when the magnet portion 15 is implemented by one magnet, the pins P are not inserted into all the insertion portions H. A circled portion indicated by a dotted line in Fig. 14B indicates a portion into which no pin is inserted.

### [Comparative Example]

Fig. 15 is a diagram illustrating a comparative example. As illustrated in Fig. 15, the support portion 11 was swung and vibrated around an θ axis together with the magnet portion 35. The magnet portion 35 was implemented by one magnet. In this case, it took about 15 seconds until the pins P were inserted into all the insertion portions H (not illustrated). The pins P and the pin receiving member M used are the same as those described above.

According to Verification Example 1, it was found that the pin having a micro size can be inserted in a short time by connecting two flat plate-shaped magnets into an integrated magnet (magnet portion) with the polarities of the magnets in the adjacent regions being different, and then sliding the integrated magnet in one direction. Accordingly, as in the comparative example, it is not necessary to apply swing and vibration, and the pin can be inserted by a simple mechanism of causing the magnet to slide. Therefore, by causing the magnet portion to slide, it is possible to cope with a substrate having a large dimension such as 12 inches. It is not necessary to increase the size of the magnet portion, which reduces a cost in terms of equipment.

### [Verification Example 2]

In Verification Example 2, as in Verification Example 1, the pins P, the pin receiving member M, and the support portion 11 were used, and the same magnet was used.

In Case 1, similar to the above comparative example, the support portion 11 was swung and vibrated around the θ axis together with the magnet portion 35. Each test was swung and vibrated for 5 seconds. This test was repeated 15 times. In each test, the number of holes into which no pin P is inserted was counted. As a result, there was no test in which the pins were inserted into all the holes. There were 2 to 17 holes into which no pin is inserted. The number of holes into which no pin is inserted also varies greatly.

In Case 2, as in Verification Example 1, the magnet portion 15 was disposed below the support portion 11 and slid back and forth in parallel along the pin receiving member M. The magnet portion 15 was implemented by one magnet of 30 mm × 30 mm × 5 mm. One test was reciprocated 5 times in 5 seconds. This test was repeated 15 times. As a result, the test in which the pins were inserted into all the holes was performed 6 times, and there were one to six holes into which no pin is inserted in a test in which the pins were not inserted into the holes.

It was found that an insertion rate was higher and the variation in the number of holes into which no pin is inserted was smaller in Case 2 than in Case **1.** Therefore, it is more effective to cause the magnet to slide than to swing and vibrate.

### [Verification Example 3]

In Verification Example **3,** as in Verification Example **1,** a test was performed by changing parameters in several cases using the pins **P,** the pin receiving member **M,** and the support portion 11. Each of one or more magnets constituting the magnet portion is used to generate the same or similar magnetic field.

In Case **3,** the magnet portion 15 was disposed below the support portion 11 and slid back and forth in parallel along the pin receiving member M as compared with Case **2.** At this time, the magnet portion 15 was implemented by connecting two magnets of 30 mm × 30 mm × 5 mm. At this time, the adjacent magnets generated magnetic fields in a direction intersecting the pin receiving member M and were connected so as to generate the magnetic fields having the opposite orientations. One test was reciprocated 5 times in 5 seconds. This test was repeated 15 times. As a result, in all the tests, the pins were inserted into all the holes.

In Case **4,** the magnet portion 15 was implemented by connecting three magnets of 30 mm × 30 mm × 5 mm as compared with Cases 2 and **3.** At this time, the adjacent magnets generated magnetic fields in a direction intersecting the pin receiving member M and were connected so as to generate the magnetic fields having the opposite orientations. One test was reciprocated 5 times in 5 seconds. This test was repeated 15 times. As a result, there were three tests in which no pin P is inserted. The number of holes into which no pin P is inserted was as small as one or two.

It was found from the results of Cases 2 to 4 that the insertion rate is higher when the magnet portion 15 is implemented by two or three magnets than when the magnet portion 15 is implemented by one magnet. The number of times of reciprocation and a time in the test in Case 4 are the same as those in the test in Case 3, and thus a movement speed of the magnet portion 15 is 400 mm/sec in Case 3 and 600 mm/sec in Case 4, and the movement speed of the magnet portion 15 is higher in Case 4. It is considered that this is because the magnetic fields at the boundary between the magnets change quickly and the posture of the pins P does not follow the change.

### [Verification Example 4]

In Case 5, in order to eliminate the influence of the movement speed of the magnet portion 15, one test was reciprocated 5 times in 6.5 seconds in Case **4.** The movement speed of the magnet portion 15 at this time was 400 mm/sec. This test was repeated 15 times. As a result, in all the tests, the pins were inserted into all the holes. From this, it was proved that the consideration in Verification Example 3 was correct.

The test results of Cases 1 to 5 are shown in Table 1. Max is a maximum value of a success rate, Min is a minimum value of the success rate, Ave is an average value of the success rate, and S is a standard deviation of the success rate.

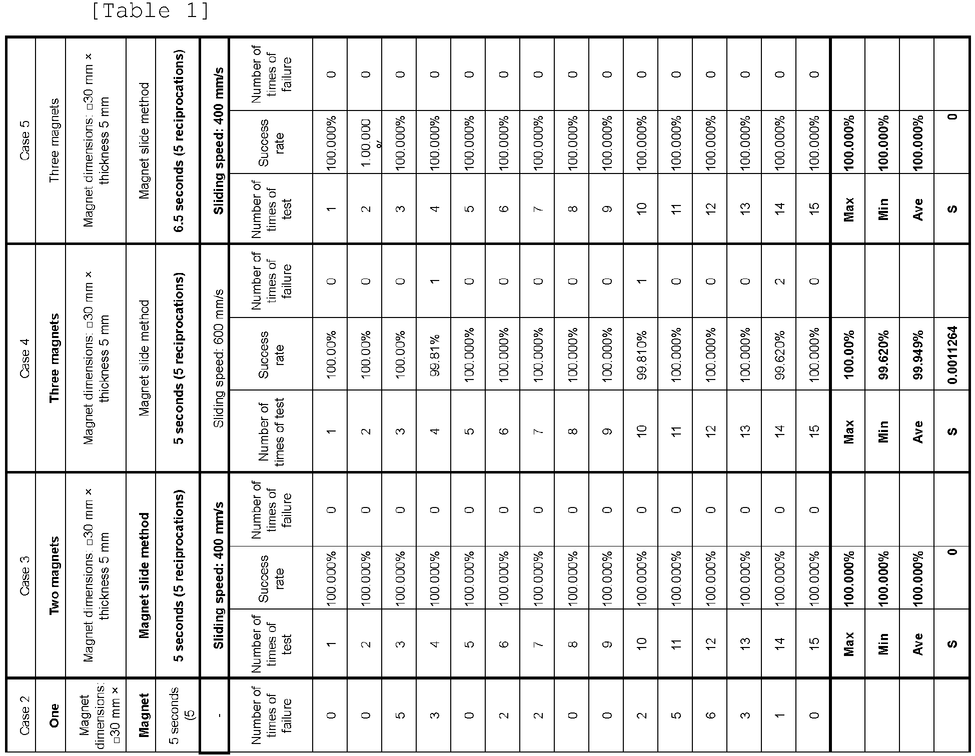

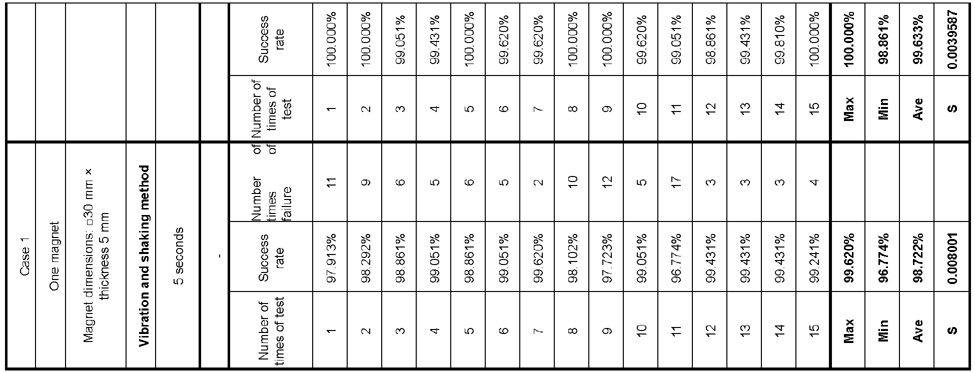

### [Verification Example 5]

In Verification Example **5,** as in Verification Example **1,** the pins **P,** the pin receiving member **M,** and the support portion 11 were used, and the magnet portion 15 was implemented by one magnet. The dimensions of one side of each magnet in the magnet portion 15 in a plan view are made different. Magnets were selected such that the magnitudes of magnetic fields generated in the magnets were the same. The movement speed of the magnet portion 15 was constant at 400 mm/sec.

In Case 6, one magnet constituting the magnet portion 15 was 15 mm × 15 mm × 5 mm. The magnet portion 15 was reciprocated 5 times in 3 seconds such that the movement speed was 400 mm/sec.

In Case 7, one magnet constituting the magnet portion 15 was 30 mm × 30 mm × 5 mm. The magnet portion 15 was reciprocated 5 times in 3.5 seconds such that the movement speed was 400 mm/sec.

In Case 8, one magnet constituting the magnet portion 15 was 60 mm × 60 mm × 5 mm. The magnet portion 15 was reciprocated 5 times in 5 seconds such that the movement speed was 400 mm/sec.

The test results of Cases 6 to 8 are shown in Table 2. Max is a maximum value of a success rate, Min is a minimum value of the success rate, Ave is an average value of the success rate, and S is a standard deviation of the success rate.

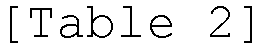

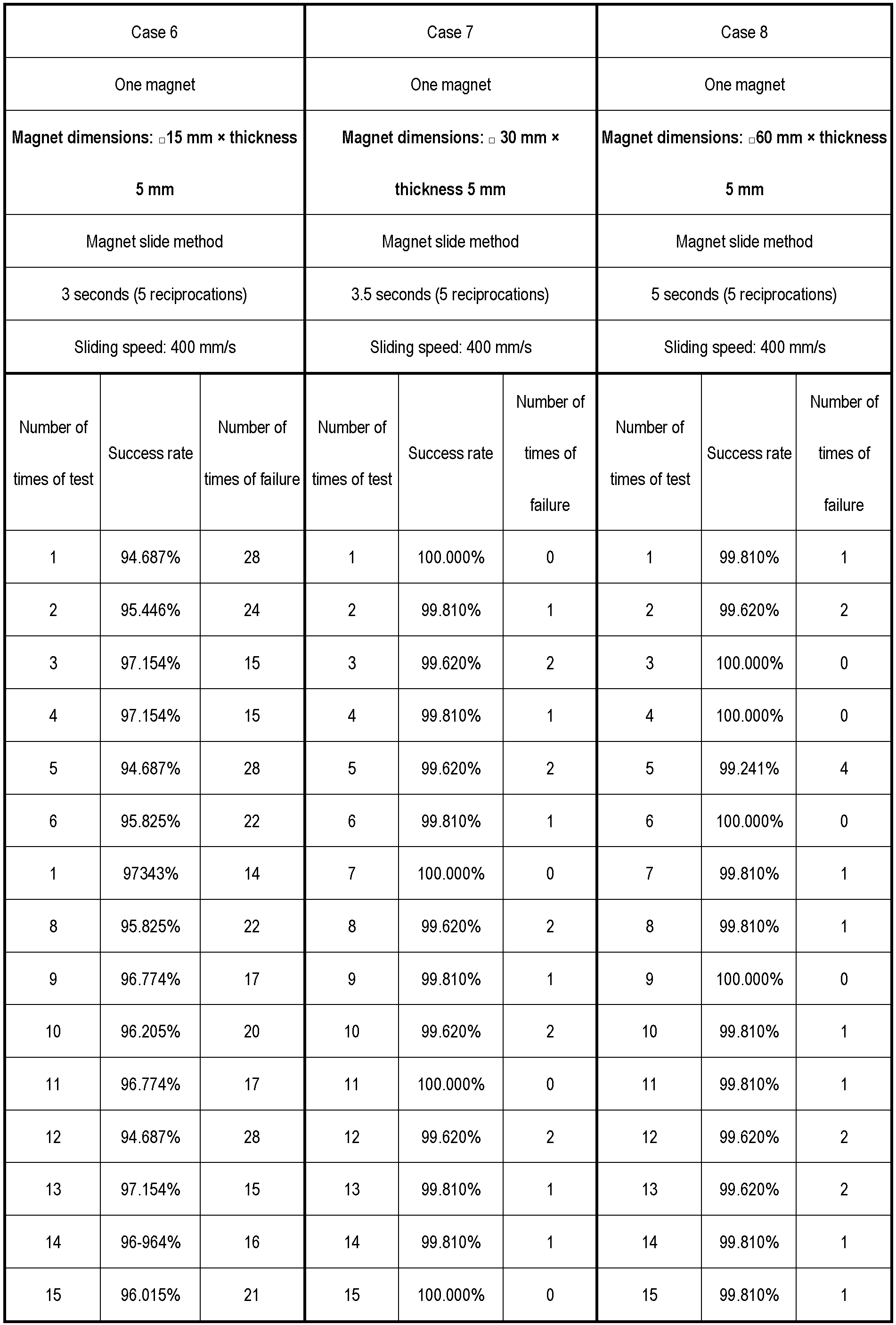

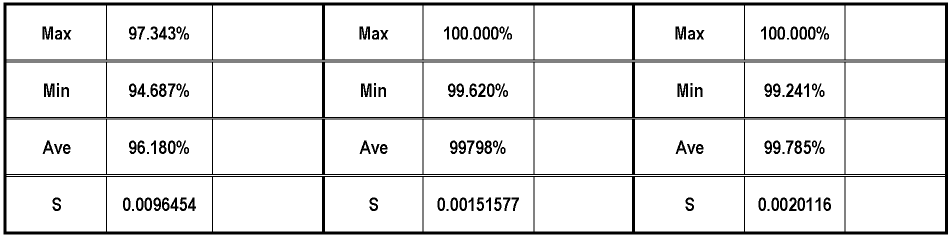

In Cases 7 and 8, the number of times of test in which no pin is inserted into the hole is small, and the number of holes into which no pin is inserted is extremely small, as compared with Case 6.

### [Verification Example 6]

In Verification Example 6, a test was performed by setting a size of one magnet to the magnet in Case 7, that is, 30 mm × 30 mm × 5 mm, and connecting these magnets. Based on the results of Verification Example 3, two adjacent magnets generated magnetic fields in a direction intersecting the pin receiving member M and were connected so as to generate the magnetic fields having the opposite orientations.

In Case 9, the magnet portion 15 was reciprocated 5 times in 3 seconds such that the movement speed of the magnet portion 15 was 600 mm/sec.

In Case 10, the magnet portion 15 was reciprocated 5 times in 5 seconds such that the movement speed of the magnet portion 15 was 400 mm/sec.

In Case 11, the magnet portion 15 was reciprocated 5 times in 10 seconds such that the movement speed of the magnet portion 15 was 200 mm/sec.

The test results of Cases 9 to 11 are shown in Table 3. Max is a maximum value of a success rate, Min is a minimum value of the success rate, Ave is an average value of the success rate, and S is a standard deviation of the success rate.

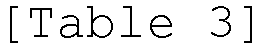

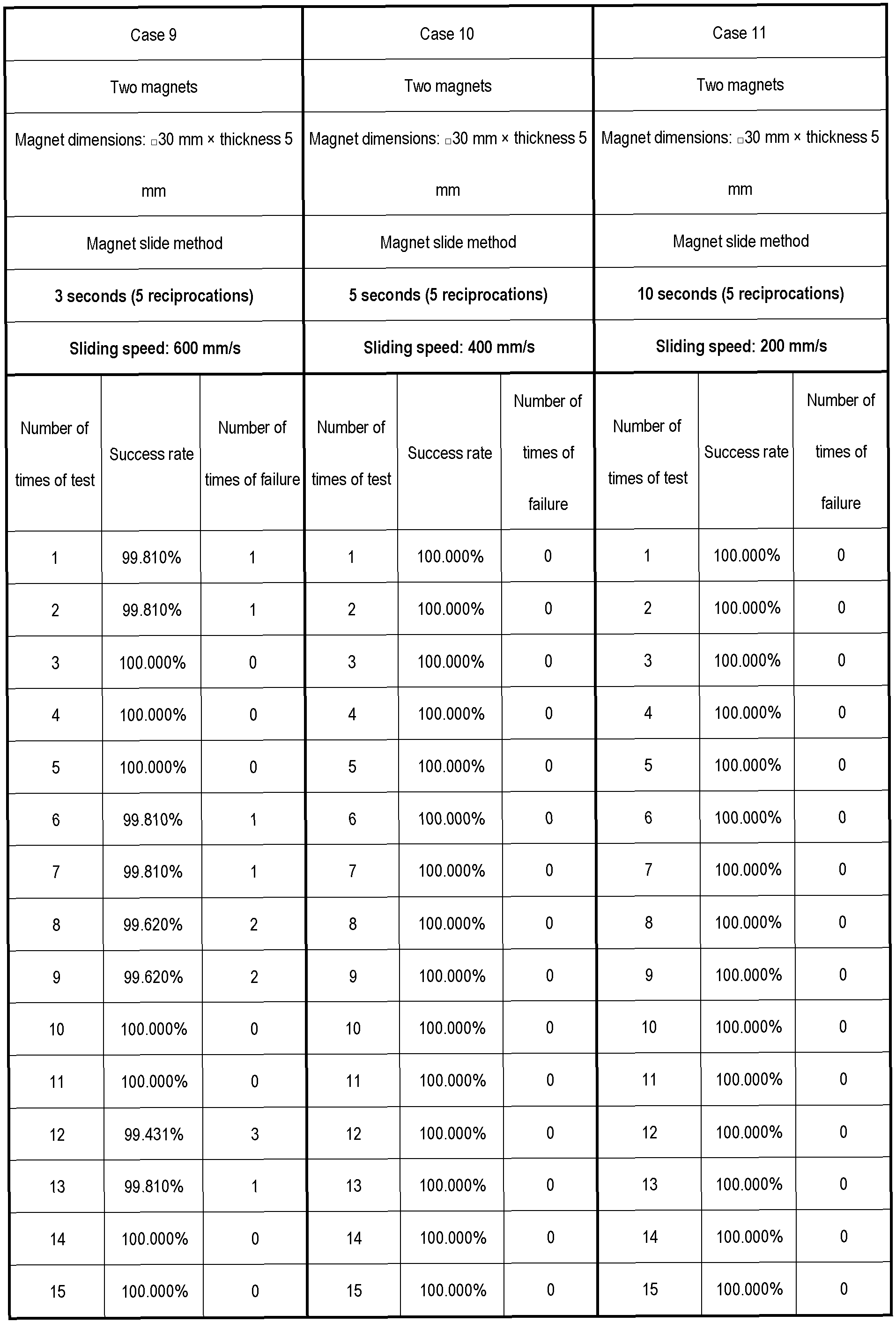

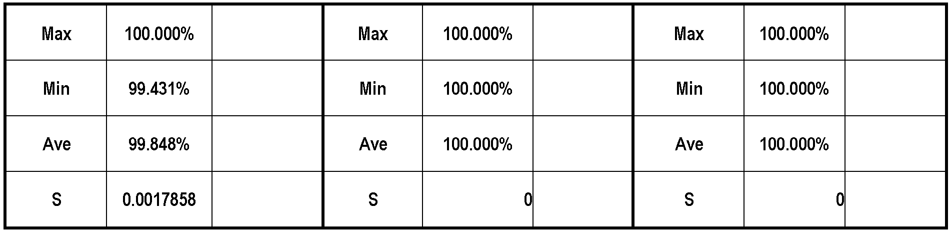

In Cases 10 and 11, the pins were inserted into all the holes in any test as compared with Case 9.

### [Verification Example 7]

In Verification Example 7, a test was performed by setting a size of one magnet to the magnet in Case 8, that is, 60 mm × 60 mm × 5 mm, and connecting these magnets. Based on the results of Verification Example 3, two adjacent magnets generated magnetic fields in a direction intersecting the pin receiving member M and were connected so as to generate the magnetic fields having the opposite orientations.

In Case 12, the magnet portion 15 was reciprocated 5 times in 6 seconds such that the movement speed of the magnet portion 15 was 600 mm/sec.

In Case 13, the magnet portion 15 was reciprocated 5 times in 8 seconds such that the movement speed of the magnet portion 15 was 400 mm/sec.

In Case 14, the magnet portion 15 was reciprocated 5 times in 16 seconds such that the movement speed of the magnet portion 15 was 200 mm/sec.

The test results of Cases 12 to 14 are shown in Table 4. Max is a maximum value of a success rate, Min is a minimum value of the success rate, Ave is an average value of the success rate, and S is a standard deviation of the success rate.

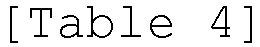

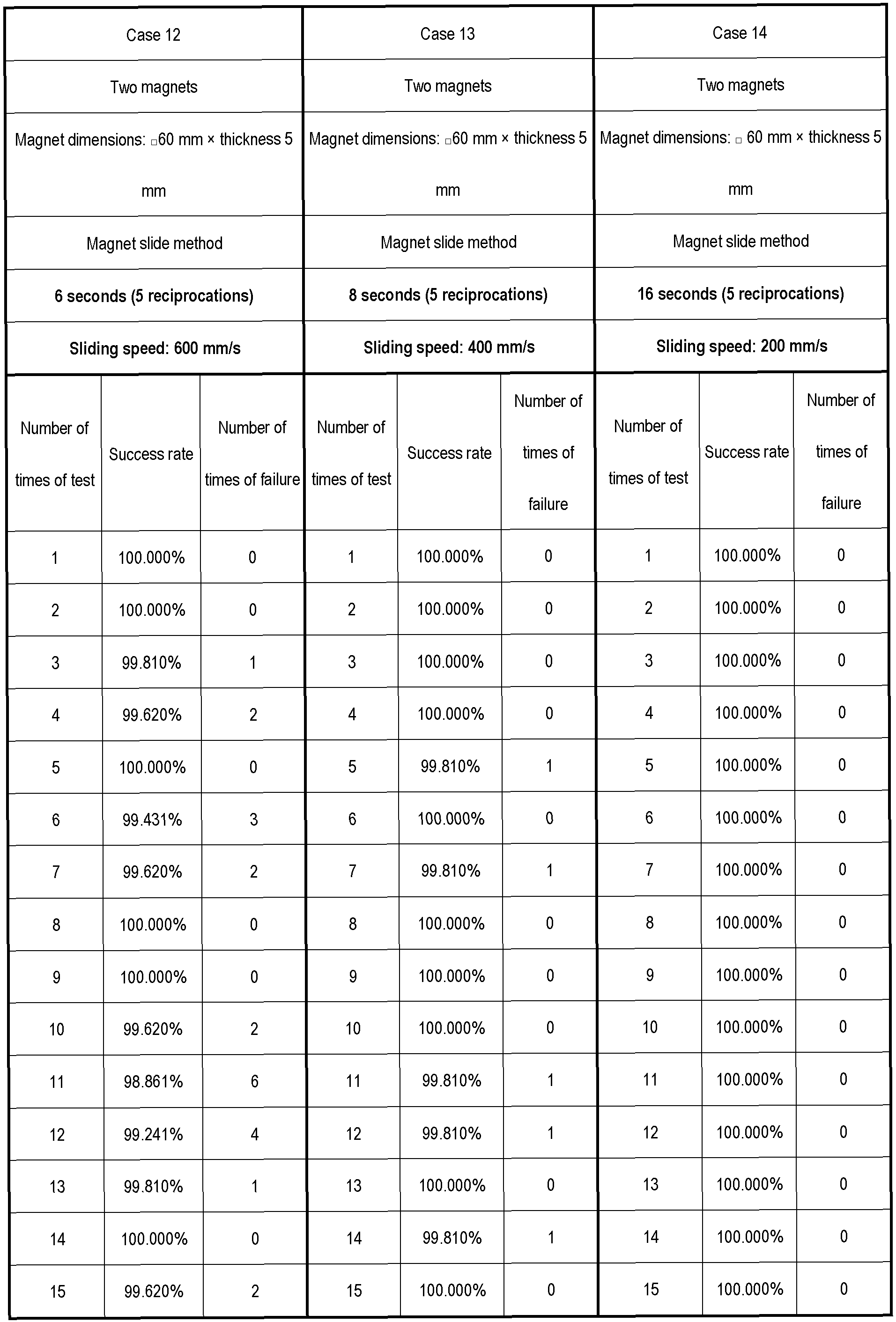

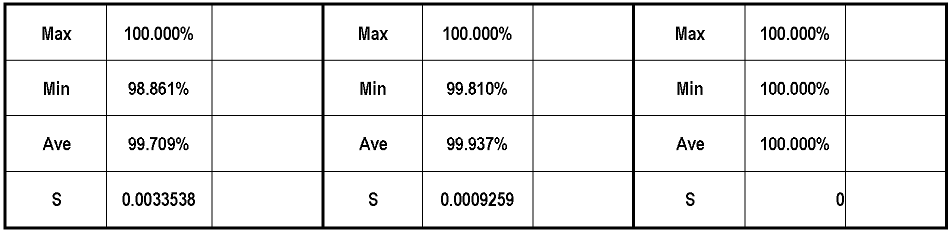

In Case 14, the pins were inserted into all the holes in any test as compared with Case 12 and Case 13.

It was found from the results of Verification Examples 6 and 7 that the pins can be inserted into all the holes by setting the movement speed of the magnet portion 15 according to the size of the magnet.

### [Verification Example 8]

In Verification Example 8, under the conditions of Case 10, the same test was performed by changing a distance between the pin receiving member M and the magnet portion 15 to 1 mm, 3.5 mm, 4.5 mm, 5.5 mm, 6.5 mm, and 7.5 mm. When the distance was 1 mm or 3.5 mm, the pins were inserted into all the holes in all the 15 tests. When the distance was increased to 4.5 mm, 5.5 mm, and 6.5 mm, no pin was inserted into one to four holes, the number of such holes increased, and the standard deviation of such holes increased to 0.000786, 0.0022528, and 0.002484. It is considered that this is less likely to be affected by the magnetic field generated in the magnet portion 15, particularly by the curved magnetic field at the boundary between the two magnets, and the pins are less likely to be inserted into all the holes. When the distance becomes 7.5 mm, there are holes into which no pin is inserted in all the 15 tests, and the number of such holes also increases from 1 to 14. Therefore, it was found that it is necessary to appropriately maintain the distance between the pin receiving member M and the magnet portion 15.

### [Verification Example 9]

Verification example 9 is different from the above verification examples in that the magnet portion is arranged in a plane in both the X-axis direction and the Y-axis direction. The magnet portion is implemented by magnets having a size of 30 mm × 30 mm × 5 mm arranged four in the X-axis direction and four in the Y-axis direction, for a total of 16 magnets. The magnet portion 15 is configured such that each magnet generates a magnetic field perpendicular to the pin receiving member M, and the adjacent magnets in the X-axis direction and the Y-axis direction have magnetic fields having opposite orientations.

The pin receiving member M was implemented by a total of nine flat plate-shaped substrates each having a square shape of 29 mm in a plan view and a thickness of 0.5 mm, three of which were arranged in the X-axis direction and three of which were arranged in the Y-axis direction. Each substrate had holes in a ring shape of six rows in the X-axis direction and six columns in the Y-axis direction. The hole had a diameter of 0.205 mm and a depth of 0.35 mm, and the number of holes was 505.

A magnet portion was disposed parallel to the surface of the pin receiving member M onto which about 7000 pins P are input, and slid along the surface of the pin receiving member M. The magnet portion is slid at a sliding speed of 400 mm/sec for 6 seconds.

As a result, it was confirmed that the pins were inserted into all the holes. Accordingly, it has been proved that it is effective to constitute a magnet portion by using a plurality of magnets that generate magnetic fields orthogonal to the pin receiving member M and arranging the plurality of magnets in a planar shape not only in one direction but also in a direction orthogonal to the one direction such that the adjacent magnets have the magnetic fields in opposite orientations.

### [Verification Example 10]

As illustrated in Fig. 1, the plate portion 5 was prepared and disposed close to the support portion 2 that supports the pin receiving member M so that the plate portion 5 forms a substantially flush surface with the pin receiving member M, and the magnet portion 3 was moved from below the pin receiving member M to below the plate portion 5. Then, the remaining pins that remain on the pin receiving member M move from the pin receiving member M to the plate portion 5, and can be completely removed from the pin receiving member M.

In the embodiments of the present invention, the magnet portions 15, 55, and the like may have not only a case in which the regions in which the magnetic fields are generated in the opposite orientations are arranged in one direction, but also a case in which the second region is provided around the first region in a plan view, and the third region is provided around the second region in some cases. In such embodiments, the second region has a non-rectangular shape such as an annular shape or a square annular shape in a plan view.

### Reference Sign List

1 pin control device
2 support portion
3 magnet portion
4 movement means
5 plate portion
6 suction device
7 suction pipe
8 side wall
10, 50 pin insertion device
11, 51 support portion
12, 52 installation region
13, 53 peripheral wall
15, 55 magnet portion
16, 56 first region
16a first magnet
17, 57 second region
17a second magnet
18, 60, 61, 62 boundary
19, 63 movement means
45 magnet portion
46 electromagnet
47 circuit unit
48a region in which magnetic field having first orientation is generated
48b region in which magnetic field having second orientation is generated
49 boundary
54 spacer
58 third region
59 fourth region
70 pin insertion device
71 support portion
72 magnet portion
72a first magnet
72b second magnet
72c third magnet
72d fourth magnet
72e fifth magnet
72f sixth magnet
72g seventh magnet
72h eighth magnet
73 movement means
74a first boundary
74b second boundary
74c third boundary
74d fourth boundary
74e fifth boundary
74f sixth boundary
74g seventh boundary
75a, 75b guide plate
76 pin supply box
80 remaining pin removal device
81 support portion
82 magnet portion
83 camera
84 analysis unit
82a boundary between close magnets
85 plate portion
86 another magnet portion
87 blower
G guide member
H insertion portion
M pin receiving member
P pin
S substrate

## Claims

1. A pin control device comprising:
a support portion that supports one or more flat plate-shaped pin receiving members each having a plurality of insertion portions; and
a magnet portion that generates a magnetic field, wherein
a posture and a position of at least a part of a plurality of pins placed on the pin receiving member are changed by causing at least one of the support portion or the magnet portion to slide relative to the other.

2. The pin control device according to claim **1,** wherein
the magnet portion is configured to at least simultaneously generate a magnetic field having a first orientation in a direction intersecting the pin receiving member and a magnetic field having a second orientation opposite to the first orientation in the direction intersecting the pin receiving member, and
by relatively moving, along the pin receiving member, a boundary between a region in which the magnetic field having the first orientation is generated and a region in which the magnetic field having the second orientation is generated, the posture and the position of at least a part of the plurality of pins placed on the pin receiving member are changed, and a part of the plurality of pins are inserted into the corresponding insertion portions.

3. The pin control device according to claim 1 or 2, wherein
a plate portion is provided close to the pin receiving member so as to form a substantially flush surface with the pin receiving member, and
the magnet portion slides from below the pin receiving member to below the plate portion or from above the pin receiving member to above the plate portion to remove, from the pin receiving member, a remaining pin on the pin receiving member without being inserted into the insertion portion.

4. A pin insertion device comprising:
a support portion that supports one or more flat plate-shaped pin receiving members each having a plurality of insertion portions; and
a magnet portion configured to at least simultaneously generate a magnetic field having a first orientation in a direction intersecting the pin receiving member and a magnetic field having a second orientation opposite to the first orientation in the direction intersecting the pin receiving member, wherein
by relatively moving, along the pin receiving member, a boundary between a region in which the magnetic field having the first orientation is generated and a region in which the magnetic field having the second orientation is generated, a posture and a position of at least a part of a plurality of pins placed on the pin receiving member are changed, and a part of the plurality of pins are inserted into the corresponding insertion portions.

5. The pin insertion device according to claim 4, wherein
the magnet portion includes a first magnet that generates the magnetic field having the first orientation and a second magnet that generates the magnetic field having the second orientation, and the first magnet and the second magnet are arranged side by side facing the pin receiving member, and
the boundary is relatively moved along the pin receiving member by moving at least one of the magnet portion or the pin receiving member along an arrangement direction of the first magnet and the second magnet.

6. The pin insertion device according to claim 4, wherein
the magnet portion includes a plurality of electromagnets arranged in an array,
the pin insertion device further comprises: a circuit unit that controls an orientation of a current flowing through the plurality of electromagnets, and
the circuit unit controls the current flowing through the plurality of electromagnets so as to move the boundary between the region in which the magnetic field having the first orientation is generated and the region in which the magnetic field having the second orientation is generated in the magnet portion.

7. A remaining pin removal device disposed close to a pin insertion device, the pin insertion device including a support portion that supports one or more flat plate-shaped pin receiving members each having a plurality of insertion portions, the remaining pin removal device comprising:
a plate portion close to the pin receiving member so as to form a substantially flush surface with the pin receiving member, wherein
a magnet portion that generates a magnetic field slides from below the pin receiving member to below the plate portion or from above the pin receiving member to above the plate portion, whereby a remaining pin on the pin receiving member without being inserted into the insertion portion is moved from the pin receiving member onto the plate portion, and the remaining pin is removed from the pin receiving member.

8. A pin insertion method comprising:
disposing a magnet portion with respect to one or more flat plate-shaped pin receiving members each having a plurality of insertion portions, the magnet portion generating a magnetic field having a first orientation in a direction intersecting the pin receiving member and a magnetic field having a second orientation opposite to the first orientation in the direction intersecting the pin receiving member; and
relatively moving, along the pin receiving member, a boundary between a region in which the magnetic field having the first orientation is generated and a region in which the magnetic field having the second orientation is generated, whereby a posture of at least a part of a plurality of pins placed on the pin receiving member is changed, and a part of the plurality of pins are inserted into the corresponding insertion portions.

9. The pin insertion method according to claim 8, wherein
the magnet portion includes a first magnet that generates the magnetic field having the first orientation and a second magnet that generates the magnetic field having the second orientation, and the first magnet and the second magnet are arranged side by side facing the pin receiving member, and
the boundary is relatively moved along the pin receiving member by moving at least one of the magnet portion or the pin receiving member along an arrangement direction of the first magnet and the second magnet.

10. The pin insertion method according to claim 8, wherein
the magnet portion includes a plurality of electromagnets arranged in an array,
a current flowing through the plurality of electromagnets is controlled so as to move the boundary between the region in which the magnetic field having the first orientation is generated and the region in which the magnetic field having the second orientation is generated in the magnet portion.

11. The pin insertion method according to any one of claims 8 to 10, wherein
the boundary between the region in which the magnetic field having the first orientation is generated and the region in which the magnetic field having the second orientation is generated in the magnet portion is moved with respect to a portion of the pin receiving member into which no pin is inserted in the plurality of insertion portions.

12. A remaining pin removal method comprising:
moving a magnet portion disposed above or below one or more flat plate-shaped pin receiving members, thereby moving, from the pin receiving member, a remaining pin on the pin receiving member without being inserted into a plurality of insertion portions of the pin receiving member and removing the remaining pin.
